# EUROPEAN PATENT SPECIFICATION

(11) **EP 1 971 975 B1**
(45) Date of publication and mention of the grant of the patent: **21.10.2015**
(21) Application number: 07701644.2
(22) Date of filing: 05.01.2007
(51) Int. Cl.: G09G 3/22, G09G 3/32

(54) **METHOD AND SYSTEM FOR DRIVING AN ACTIVE MATRIX DISPLAY CIRCUIT**
VERFAHREN UND SYSTEM ZUR ANSTEUERUNG EINER AKTIVMATRIXANZEIGESCHALTUNG
PROCÉDÉ ET SYSTÈME POUR COMMANDER UN CIRCUIT D AFFICHAGE DE MATRICE ACTIVE

(30) Priority: 09.01.2006 CA 2535233; 27.06.2006 CA 2551237
(43) Date of publication of application: 24.09.2008
(60) Divisional application: 12156251.6
(73) Proprietor: Ignis Innovation Inc., Waterloo, Ontario N2V 2C5 (CA)
(72) Inventor: NATHAN, Arokia, Cambridge CB3 ODL (GB); CHAJI, Reza, G., Waterloo, Ontario N2V 2S3 (CA)
(74) Representative: Grünecker Patent- und Rechtsanwälte PartG mbB
(86) International application number: PCT/CA2007/000013
(87) International publication number: WO 2007/079572

(56) References cited:
- EP-A- 1 439 520
- EP-A- 1 517 290
- EP-A2- 1 102 234
- CA-A1- 2 438 363
- CA-A1- 2 526 782
- US-A1- 2003 197 663
- US-B1- 6 859 193
- REZA CHAJI G ET AL: "52.2: A Low-Cost Stable Amorphous Silicon AMOLED Display with Full VT and VOLED Shift Compensation" SID 2007, 2007 SID INTERNATIONAL SYMPOSIUM, SOCIETY FOR INFORMATION DISPLAY, LOS ANGELES, USA, vol. XXXVIII, 20 May 2007 (2007-05-20), pages 1580-1583, XP007013323 ISSN: 0007-966X

## Description

### FIELD OF INVENTION

The invention relates to a light emitting device, and more specifically to a method and system for driving a pixel circuit having a light emitting device.

### BACKGROUND OF THE INVENTION

Electro-luminance displays have been developed for a wide variety of devices, such as cell phones. In particular, active-matrix organic light emitting diode (AMOLED) displays with amorphous silicon (a-Si), poly-silicon, organic, or other driving backplane have become more attractive due to advantages, such as feasible flexible displays, its low cost fabrication, high resolution, and a wide viewing angle.

An AMOLED display includes an array of rows and columns of pixels, each having an organic light emitting diode (OLED) and backplane electronics arranged in the array of rows and columns. Since the OLED is a current driven device, the pixel circuit of the AMOLED should be capable of providing an accurate and constant drive current.

There is a need to provide a method and system that is capable of providing constant brightness with high accuracy and reducing the effect of the aging of the pixel circuit and the instability of backplane and a light emitting device.

EP 0 466 676 A2 describes an active matrix type display apparatus and drive circuit thereof, where each of picture elements comprises an input transistor for accepting signal current from a data line when a scanning line is selected, a conversion transistor for converting the signal current into a voltage and for holding thus converted voltage, and a drive transistor for driving a light emitting device with drive current corresponding to the converted voltage. The conversion transistor flows the signal current to its channel to generate the voltage corresponding to the converted voltage and a capacitor restrains the generated voltage. Further, the drive transistor flows the drive current corresponding to the voltage stored in the capacitor. In this case a threshold voltage of the drive transistor is set not to be smaller than a threshold voltage of the conversion transistor, thereby a leakage current flowing through the light emitting device is suppressed.

US 2003/197663 (A1) describes an electroluminescent display panel and method for operating the same. The electroluminescent display panel has a plurality of unit pixels defined by a plurality of gate lines, and a plurality of source lines running perpendicular to each other. The unit pixel includes a first switching device, a capacitor having a first terminal connected to an output terminal of the first switching device, and a second terminal connected to a power source voltage terminal, a second switching device connected to the power source voltage terminal, an electroluminescent part, and a light emission suppressing part connected to the one end of the capacitor for turning off the electroluminescent part for a preset period during a period before the present frame is operated, by receiving an enable signal that causes discharge of the capacitor and discharging a charge stored in the capacitor.

### SUMMARY OF THE INVENTION

It is an object of the invention to provide a method and system that obviates or mitigates at least one of the disadvantages of existing systems.

This object is achieved by the present invention as claimed in the independent claim 1. Advantageous and preferred embodiments of the present invention are defined by the dependent claims.

In accordance with an aspect there is provided a system a display system, including a drive circuit for a pixel having a light emitting device. The drive circuit includes a drive transistor connected to the light emitting device. The drive transistor includes a gate terminal, a first terminal and a second terminal. The drive circuit includes a first transistor including a gate terminal, a first terminal and a second terminal, the gate terminal of the first transistor being connected to a select line, the first terminal of the first transistor being connected to a data line, the second terminal of the first transistor being connected to the gate terminal of the drive transistor. The drive circuit includes a circuit for adjusting the gate voltage of the drive transistor, the circuit including a discharging transistor having a gate terminal, a first terminal and a second terminal, the gate terminal of the discharging transistor being connected to the gate terminal of the drive transistor at a node, the voltage of the node being discharged through the discharging transistor. The drive circuit includes a storage capacitor including a first terminal and a second terminal, the first terminal of the storage capacitor being connected to the gate terminal of the drive transistor at the node.

The display system may include a display array having a plurality of pixel circuits arranged in rows and columns, each of the pixel circuits including the drive circuit, and a driver for driving the display array. The gate terminal of the second transistor is connected to a bias line. The bias line may be shared by more than one pixel circuit of the plurality of pixel circuits.

In accordance with a further aspect there is provided a method for the display system. The display system includes a driver for providing a programming cycle, a compensation cycle and a driving cycle for each row. The method includes the steps of at the programming cycle for a first row, selecting the address line for the first row and providing programming data to the first row, at the compensation cycle for the first row, selecting the adjacent address line for a second row adjacent to the first row and disenabling the address line for the first row, and at the driving cycle for the first row, disenabling the adjacent address line.

In accordance with a further aspect there is provided a display system, including one or more than one pixel circuit, each including a light emitting device and a drive circuit. The drive circuit includes a drive transistor including a gate terminal, a first terminal and a second terminal, the drive transistor being between the light emitting device and a first power supply. The drive circuit includes a switch transistor including a gate terminal, a first terminal and a second terminal, the gate terminal of the switch transistor being connected to a first address line, the first terminal of the switch transistor being connected to a data line, the second terminal of the switch transistor being connected to the gate terminal of the drive transistor. The drive circuit includes a circuit for adjusting the gate voltage of the drive transistor, the circuit including a sensor for sensing energy transfer from the pixel circuit and a discharging transistor, the sensor having a first terminal and a second terminal, a property of the sensor varying in dependence upon the sensing result, the discharging transistor having a gate terminal, a first terminal and a second terminal, the gate terminal of the discharging transistor being connected to a second address line, the first terminal of the discharging transistor being connected to the gate terminal of the drive transistor at a node, the second terminal of the discharging transistor being connected to the first terminal of the sensor. The drive circuit includes a storage capacitor including a first terminal and a second terminal, the first terminal of the storage capacitor being connected to the gate terminal of the drive transistor at the node.

In accordance with a further aspect there is provided a method for a display system, including the step of implementing an in-pixel compensation.

In accordance with a further aspect there is provided a method for a display system, including the step of implementing an of-panel compensation.

In accordance with a further aspect there is provided a method for a display system, which includes a pixel circuit having a sensor, including the step of reading back the aging of the sensor.

In accordance with a further aspect there is provided a display system, including a display array including a plurality of pixel circuits arranged in rows and columns, each including a light emitting device and a drive circuit; and a drive system for driving the display array. The drive circuit includes a drive transistor including a gate terminal, a first terminal and a second terminal, the drive transistor being between the light emitting device and a first power supply. The drive circuit includes a first transistor including a gate terminal, a first terminal and a second terminal, the gate terminal of the first transistor being connected to an address line, the first terminal of the first transistor being connected to a data line, the second terminal of the first transistor being connected to the gate terminal of the drive transistor. The drive circuit includes a circuit for adjusting the gate voltage of the drive transistor, the circuit including a second transistor, the second transistor having a gate terminal, a first terminal and a second terminal, the gate terminal of the second transistor being connected to a control line, the first terminal of the second transistor being connected to the gate terminal of the drive transistor. The drive circuit includes a storage capacitor including a first terminal and a second terminal, the first terminal of the storage capacitor being connected to the gate terminal of the drive transistor. The drive system drives the pixel circuit so that the pixel circuit is turned off for a portion of a frame time.

In accordance with a further aspect there is provided a method for a display system having a display array and a driver system. The drive system provides a frame time having a programming cycle, a discharge cycle, an emission cycle, a reset cycle, and a relaxation cycle, for each row. The method includes the steps of at the programming cycle, programming the pixel circuits on the row by activating the address line for the row; at the discharge cycle, partially discharging the voltage on the gate terminal of the drive transistor by deactivating the address line for the row and activating the control line for the row; at the emission cycle, deactivating the control line for the row, and controlling the light emitting device by the drive transistor; at the reset cycle, discharging the voltage on the gate terminal of the drive transistor by activating the control line for the row; and at the relaxation cycle, deactivating the control line for the row.

### BRIEF DESCRIPTION OF THE DRAWINGS

These and other features of the invention will become more apparent from the following description in which reference is made to the appended drawings wherein:
Figure 1 is a diagram illustrating an example of a pixel circuit to which a pixel drive scheme in accordance with an embodiment of the present invention is applied;
Figure 2 is a diagram illustrating another example of a pixel circuit having a drive circuit of Figure 1;
Figure 3 is a timing diagram for an example of a method of driving a pixel circuit in accordance with an embodiment of the present invention;
Figure 4 is a diagram illustrating an example of a display system for the drive circuit of Figures 1 and 2;
Figure 5 is a diagram illustrating an example of a pixel circuit to which a pixel drive scheme in accordance with another embodiment of the present invention is applied;
Figure 6 is a diagram illustrating another example of a drive circuit of Figure 5;
Figure 7 is a diagram illustrating a further example of the drive circuit of Figure 5;
Figure 8 is a diagram illustrating another example of a pixel circuit having the drive circuit of Figure 5;
Figure 9 is a timing diagram for an example of a method of driving a pixel circuit in accordance with another embodiment of the present invention;
Figure 10 is a diagram illustrating an example of a display system for the drive circuit of Figures 5 and 8;
Figure 11 is a diagram illustrating an example of a display system for the drive circuit of Figures 6 and 7;
Figure 12 is a graph illustrating simulation results for the pixel circuit of Figure 1;
Figure 13 is a diagram illustrating an example of a pixel circuit to which a pixel drive scheme in accordance with a further embodiment of the present invention is applied;
Figure 14 is a diagram illustrating another example of a pixel circuit having a drive circuit of Figure 13;
Figure 15 is a timing diagram for an example of a method of driving a pixel circuit in accordance with a further embodiment of the present invention;
Figure 16 is a diagram illustrating an example of a display system for the drive circuit of Figures 13 and 14;
Figure 17 is a graph illustrating simulation results for the pixel circuit of Figure 5;
Figure 18 is a graph illustrating simulation results for the pixel circuit of Figure 5;
Figure 19 is a timing diagram for the operation of the display system of Figure 16.
Figure 20 is a diagram illustrating an example of a pixel circuit to which a pixel drive scheme in accordance with a illustrative example for understanding the present invention is applied;
Figure 21 is a diagram illustrating another example of a pixel circuit having the drive circuit of Figure 20;
Figure 22 is a timing diagram illustrating an example of a method of driving a pixel circuit;
Figure 23 is a diagram illustrating an example of a display system for the drive circuit of Figures 20 and 21;
Figure 24 is a diagram illustrating another example of a display system for the drive circuit of Figures 20 and 21;
Figure 25 is a diagram illustrating an example of a pixel system;
Figure 26 is a diagram illustrating an example of a display system having a read back circuit of Figure 25;
Figure 27 is a diagram illustrating another example of a display system having the read back circuit of Figure 25;
Figure 28 is a timing diagram illustrating an example of a method of driving a pixel circuit;
Figure 29 is a diagram illustrating an example of a method of extracting the aging of a sensor of Figure 25;
Figure 30 is a diagram illustrating an example of a pixel system;
Figure 31 is a diagram illustrating an example of a display system having a read back circuit of Figures 30;
Figure 32 is a diagram illustrating another example of a display system having the read back circuit of Figure 30;
Figure 33 is a timing diagram illustrating an example of a method of driving a pixel circuit;
Figure 34 is a timing diagram illustrating another example of a method of extracting the aging of a sensor of Figure 30;
Figure 35 is a diagram illustrating an example of a pixel circuit to which a pixel drive scheme;
Figure 36 is a timing diagram for an example of a method of driving a pixel circuit;
Figure 37 is a diagram illustrating an example of a display system having the pixel circuit of Figure 35; and
Figure 38 is a diagram illustrating another example of a display system having the pixel circuit of Figure 35.

### DETAILED DESCRIPTION

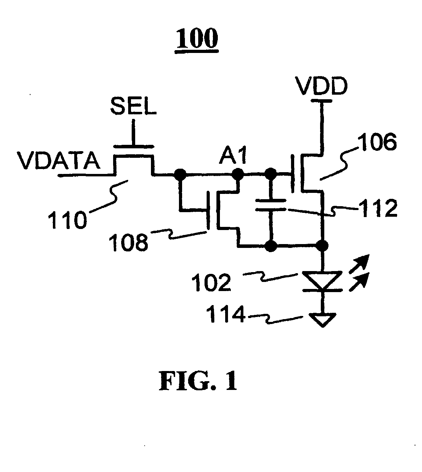

Figure 1 illustrates an example of a pixel circuit to which a pixel drive scheme in accordance with an embodiment of the present invention is applied. The pixel circuit 100 of Figure 1 includes an OLED 102 and a drive circuit 104 for driving the OLED 102. The drive circuit 104 includes a drive transistor 106, a discharging transistor 108, a switch transistor 110, and a storage capacitor 112. The OLED 102 includes, for example, an anode electrode, a cathode electrode and an emission layer between the anode electrode and the cathode electrode.

In the description below, "pixel circuit" and "pixel" are used interchangeably. In the description below, "signal" and "line" may be used interchangeably. In the description below, the terms "line" and "node" may be used interchangeably. In the description, the terms "select line" and "address line" may be used interchangeably. In the description below, "connect (or connected)"and "couple (or coupled)" may be used interchangeably, and may be used to indicate that two or more elements are directly or indirectly in physical or electrical contact with each other.

In one example, the transistors 106, 108 and 110 are n-type transistors. In another example, the transistors 106, 108 and 110 are p-type transistors or a combination of n-type and p-type transistors. In one example, each of the transistors 106, 108 and 110 includes a gate terminal, a source terminal and a drain terminal.

The transistors 106, 108 and 110 may be fabricated using amorphous silicon, nano/micro crystalline silicon, poly silicon, organic semiconductors technologies (e.g., organic TFT), NMOS/PMOS technology or CMOS technology (e.g., MOSFET).

The drive transistor 106 is provided between a voltage supply line VDD and the OLED 102. One terminal of the drive transistor 106 is connected to VDD. The other terminal of the drive transistor 106 is connected to one electrode (e.g., anode electrode) of the OLED 102. One terminal of the discharging transistor 108 and its gate terminal are connected to the gate terminal of drive transistor 106 at node A1. The other terminal of the discharging transistor 108 is connected to the OLED 102. The gate terminal of the switch transistor 110 is connected to a select line SEL. One terminal of the switch transistor 110 is connected to a data line VDATA. The other terminal of the switch transistor 110 is connected to node A1. One terminal of the storage capacitor 112 is connected to node A1. The other terminal of the storage capacitor 112 is connected to the OLED 102. The other electrode (e.g., cathode electrode) of the OLED 102 is connected to a power supply line (e.g., common ground) 114.

The pixel circuit 100 provides constant averaged current over the frame time by adjusting the gate voltage of the drive transistor 106, as described below.

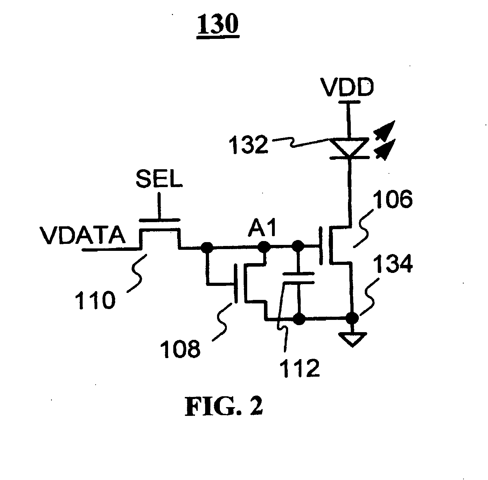

Figure 2 illustrates anther example of a pixel circuit having the drive circuit 104 of Figure 1. The pixel circuit 130 is similar to the pixel circuit 100 of Figure 1. The pixel circuit 130 includes an OLED 132. The OLED 132 may be same or similar to the OLED 102 of Figure 1. In the pixel circuit 130, the drive transistor 106 is provided between one electrode (e.g., cathode electrode) of the OLED 132 and a power supply line (e.g., common ground) 134. One terminal of the discharging transistor 138 and one terminal of the storage capacitor 112 are connected to the power supply line 134. The other electrode (e.g., anode electrode) of the OLED 132 is connected to VDD.

The pixel circuit 130 provides constant averaged current over the frame time, in a manner similar to that of the pixel circuit 100 of Figure 1.

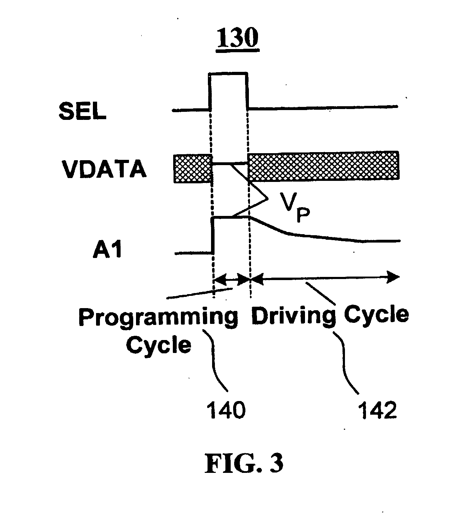

Figure 3 illustrates an example of method of driving a pixel circuit in accordance with an embodiment of the present invention. The waveforms of Figure 3 are applied to a pixel circuit (e.g., 100 of Figure 1, 130 of Figure 2) having the drive circuit 104 of Figures 1 and 2.

The operation cycle of Figure 3 includes a programming cycle 140 and a driving cycle 142. Referring to Figures 1 to 3, during the programming cycle 140, node A1 is charged to a programming voltage through the switch transistor 110 while the select line SEL is high. During the driving cycle 142, node A 1 is discharged through the discharging transistor 108. Since the drive transistor 106 and the discharging transistor 108 have the same bias condition, they experience the same threshold voltage shift. Considering that the discharge time is a function of transconductance of the discharging transistor 108, the discharge time increases as the threshold voltage of the drive transistor 106/the discharging transistor 108 increases. Therefore, the average current of the pixel (100 of Figure 1, 130 of Figure 2) over the frame time remains constant. In an example, the discharging transistor is a very weak transistor with short width (W) and long channel length (L). The ratio of the width (W) to the length (L) may change based on different situations.

In addition, in the pixel circuit 130 of Figure 2, an increase in the OLED voltage for the OLED 132 results in longer discharge time. Thus, the averaged pixel current will remain constant even after the OLED degradation.

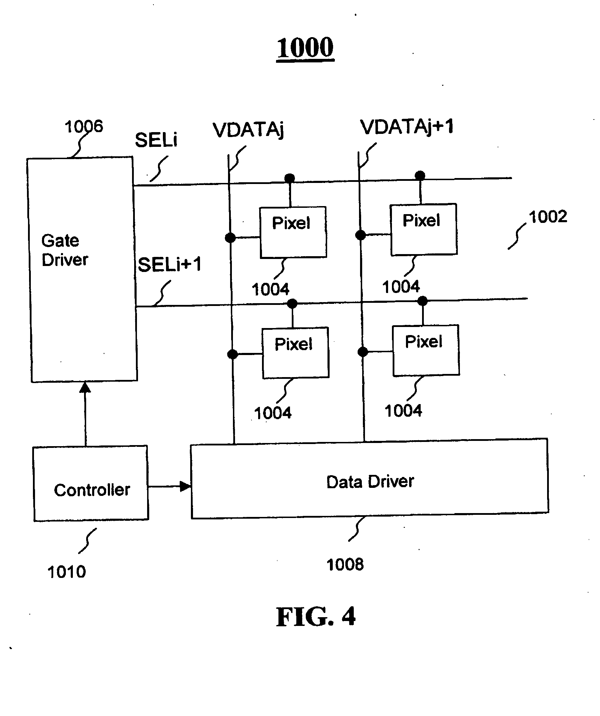

Figure 4 illustrates an example of a display system for the drive circuit of Figures 1 and 2. The display system 1000 of Figure 4 includes a display array 1002 having a plurality of pixels 1004. The pixel 1004 includes the drive circuit 104 of Figures 1 and 2, and may be the pixel circuit 100 of Figure 1 or the pixel circuit 130 of Figure 2.

The display array 1002 is an active matrix light emitting display. In one example, the display array 1002 is an AMOLED display array. The display array 1002 may be a single color, multi-color or a fully color display, and may include one or more than one electroluminescence (EL) element (e.g., organic EL). The display array 1002 may be used in mobiles, personal digital assistants (PDAs), computer displays, or cellular phones.

Select lines SELi and SELi+1 and data lines VDATAj and VDATAj+1 are provided to the display array 1002. Each of the select lines SELi and SELi+1 corresponds to SEL of Figures 1 and 2. Each of the data lines VDATAj and VDATAj+1 corresponds to VDATA of Figures 1 and 2. The pixels 1004 are arranged in rows and columns. The select line (SELi, SELi+1) is shared between common row pixels in the display array 1002. The data line (VDATAj, VDATAj+1) is shared between common column pixels in the display array 1002.

In Figure 4, four pixels 1004 are shown. However, the number of the pixels 1004 may vary in dependence upon the system design, and does not limited to four. In Figure 4, two select lines and two data lines are shown. However, the number of the select lines and the data lines may vary in dependence upon the system design, and does not limited to two.

A gate driver 1006 drives SELi and SELi+1. The gate driver 1006 may be an address driver for providing address signals to the address lines (e.g., select lines). A data driver 1008 generates a programming data and drives VDATAj and VDATAj+1. A controller 1010 controls the drivers 1006 and 1008 to drive the pixels 1004 as described above.

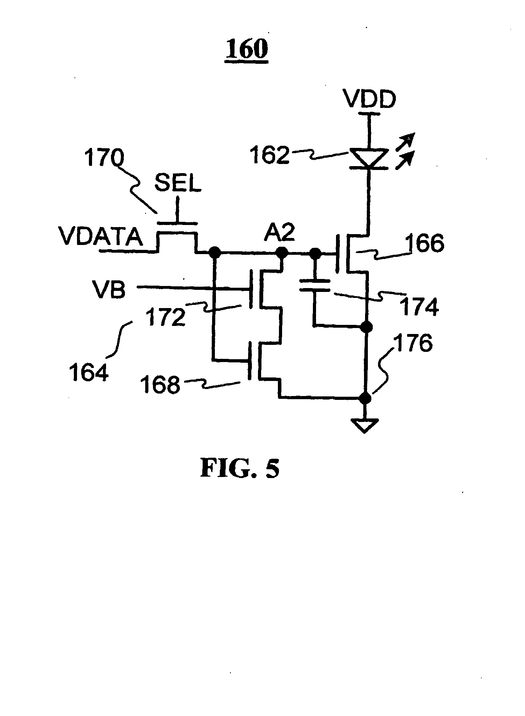

Figure 5 illustrates an example of a pixel circuit to which a pixel drive scheme in accordance with another embodiment of the present invention. The pixel circuit 160 of Figure 5 includes an OLED 162 and a drive circuit 164 for driving the OLED 162. The drive circuit 164 includes a drive transistor 166, a discharging transistor 168, first and second switch transistors 170 and 172, and a storage capacitor 174.

The pixel circuit 160 is similar to the pixel circuit 130 of Figure 2. The drive circuit 164 is similar to the drive circuit 104 of Figures 1 and 2. The transistors 166, 168 and 170 correspond to the transistors 106, 108 and 110 of Figures 1 and 2, respectively. The transistors 166, 168, and 170 may be same or similar to the transistors 106, 108 and 110 of Figures 1 and 2. The storage capacitor 174 corresponds to the storage capacitor 112 of Figures 1 and 2. The storage capacitor 174 may be same or similar to the storage capacitor 112 of Figures 1 and 2. The OLED 162 corresponds to the OLED 132 of Figure 2. The OLED 162 may be same or similar to the OLED 132 of Figure 2.

In one example, the switch transistor 172 is a n-type transistor. In another example, the switch transistor 172 is a p-type transistor. In one example, each of the transistors 166, 168, 170, and 172 includes a gate terminal, a source terminal and a drain terminal.

The transistors 166, 168, 170 and 172 may be fabricated using amorphous silicon, nano/micro crystalline silicon, poly silicon, organic semiconductors technologies (e.g., organic TFT), NMOS/PMOS technology or CMOS technology (e.g., MOSFET).

In the pixel circuit 160, the switch transistor 172 and the discharging transistor 168 are connected in series between the gate terminal of the drive transistor 166 and a power supply line (e.g., common ground) 176. The gate terminal of the switch transistor 172 is connected to a bias voltage line VB. The gate terminal of the discharging transistor 168 is connected to the gate terminal of the drive transistor at node A2. The drive transistor 166 is provided between one electrode (e.g., cathode electrode) of the OLED 162 and the power supply line 176. The gate terminal of the switch transistor 170 is connected to SEL. One terminal of the switch transistor 170 is connected to VDATA. The other terminal of the switch transistor 170 is connected to node A2. One terminal of the storage capacitor 174 is connected to node A2. The other terminal of the storage capacitor 174 is connected to the power supply line 176.

The pixel circuit 160 provides constant averaged current over the frame time by adjusting the gate voltage of the drive transistor 166, as described below.

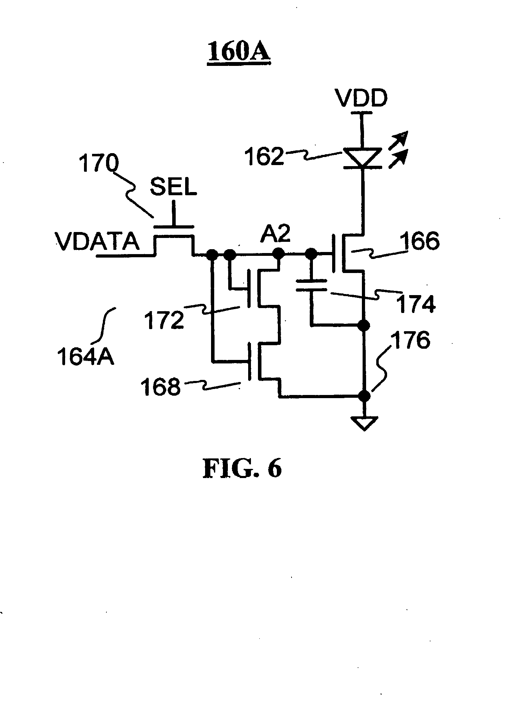

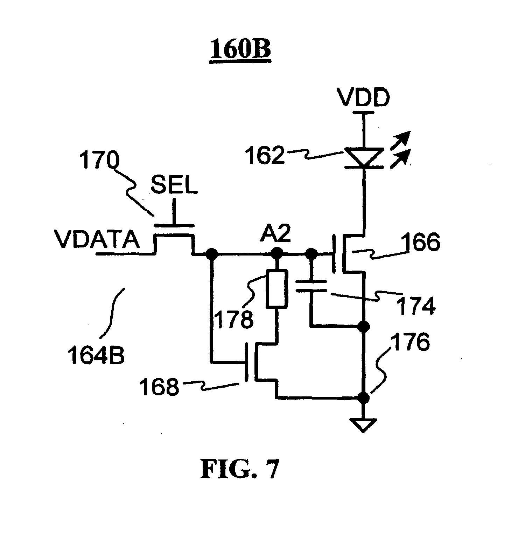

In one example, the bias voltage line VB of Figure 5 may be shared between the pixels of the entire panel. In another example, the bias voltage VB may be connected to node A2, as shown in Figure 6. The pixel circuit 160A of Figure 6 includes a drive circuit 164A. The drive circuit 164A is similar to the drive circuit 164 of Figure 5. However, in the drive circuit 164A, the gate terminal of the switch transistor 172 is connected to node A2. In a further example, the switch transistor 172 of Figure 5 may be replaced with a resistor, as shown in Figure 7. The pixel circuit 160B of Figure 7 includes a drive circuit 164B. The drive circuit 164B is similar to the drive circuit 164 of Figure 5. However, in the drive circuit 164B, a resistor 178 and the discharging transistor 168 are connected in series between node A2 and the power supply line 176.

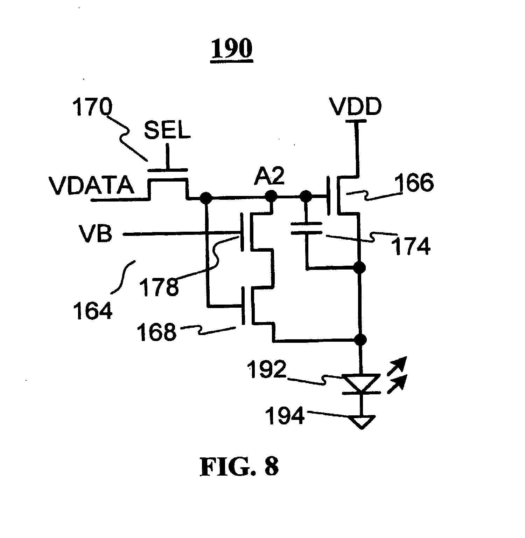

Figure 8 illustrates another example of a pixel circuit having the drive circuit 164 of Figure 5. The pixel circuit 190 is similar to the pixel circuit 160 of Figure 5. The pixel circuit 190 includes an OLED 192. The OLED 192 may be same or similar to the OLED 162 of Figure 5. In the pixel circuit 190, the drive transistor 166 is provided between one electrode (e.g., anode electrode) of the OLED 192 and VDD. One terminal of the discharging transistor 168 and one terminal of the storage capacitor 174 are connected to the OLED 192. The other electrode (e.g., cathode electrode) of the OLED 192 is connected to a power supply line (e.g., common ground) 194.

In one example, the bias voltage VB of Figure 8 is shared between the pixels of the entire panel. In another example, the bias voltage VB of Figure 8 is connected to node A2, as it is similar to that of Figure 6. In a further example, the switch transistor 172 of Figure 8 is replaced with a resistor, as it is similar to that of Figure 7.

The pixel circuit 190 provides constant averaged current over the frame time, in a manner similar to that of the pixel circuit 160 of Figure 5.

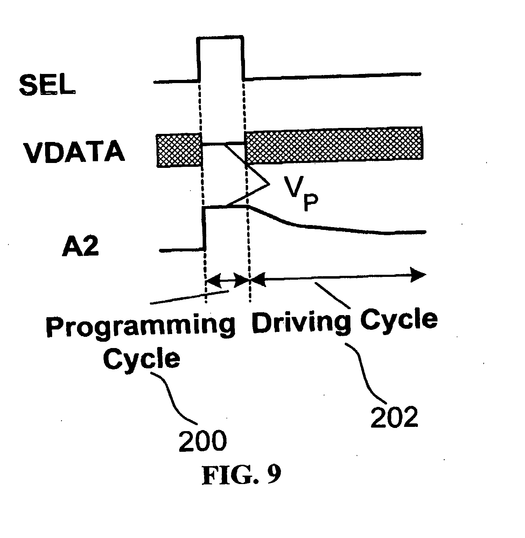

Figure 9 illustrates an example of method of driving a pixel circuit in accordance with another embodiment of the present invention. The waveforms of Figure 9 are applied to a pixel circuit (e.g., 160 of Figure 5, 190 of Figure 8) having the drive circuit 164 of Figures 5 and 8.

The operation cycle of Figure 9 includes a programming cycle 200 and a driving cycle 202. Referring to Figures 5, 8 and 9, during the programming cycle 200, node A2 is charged to a programming voltage (Vp) through the switch transistor 170 while SEL is high. During the driving cycle 202, node A2 is discharged through the discharging transistor 168. Since the drive transistor 166 and the discharging transistor 168 have the same bias condition, they experience the same threshold voltage shift. Considering that the discharge time is a function of transconductance of the discharging transistor 168, the discharge time increases as the threshold voltage of the drive transistor 166/the discharging transistor 168 increases. Therefore, the average current of the pixel (160 of Figure 5, 190 of Figure 8) over the frame time remains constant. Here, the switch transistor 172 forces the discharging transistor 168 in the linear regime of operation, and so reduces feedback gain. Therefore, the discharging transistor 168 may be a unity transistor with the minimum channel length and width. The width and length of the unity transistor are the minimum allowed by the technology.

In addition, in the pixel circuit 190 of Figure 8, an increase in the OLED voltage for the OLED 192 results in longer discharge time. Thus, the averaged pixel current will remain constant even after the OLED degradation.

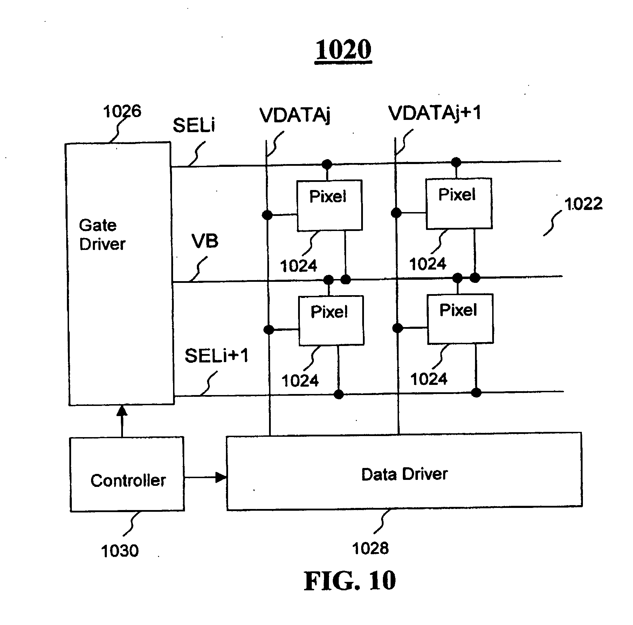

Figure 10 illustrates an example of a display system for the drive circuit of Figures 5 and 8. The display system 1020 of Figure 10 includes a display array 1022 having a plurality of pixels 1024. The pixel 1024 includes the drive circuit 164 of Figures 5 and 8, and may be the pixel circuit 130 of Figure 5 or the pixel circuit 190 of Figure 8.

The display array 1022 is an active matrix light emitting display. In one example, the display array 1022 is an AMOLED display array. The display array 1022 may be a single color, multi-color or a fully color display, and may include one or more than one EL element (e.g., organic EL). The display array 1022 may be used in mobiles, PDAs, computer displays, or cellular phones.

Each of select lines SELi and SELi+1 corresponds to SEL of Figures 5 and 8. VB corresponds to VB of Figures 5 and 8. Each of data lines VDATAj and VDATAj+1 corresponds to VDATA of Figures 5 and 8. The pixels 1024 are arranged in rows and columns. The select line (SELi, SELi+1) is shared between common row pixels in the display array 1022. The data line (VDATAj, VDATAj+1) is shared between common column pixels in the display array 1022. The bias voltage line VB is shared by the ith and (i+1)th rows. In another example, the VB may be shared by the entire array 1022.

In Figure 10, four pixels 1024 are shown. However, the number of the pixels 1024 may vary in dependence upon the system design, and does not limited to four. In Figure 10, two select lines and two data lines are shown. However, the number of the select lines and the data lines may vary in dependence upon the system design, and does not limited to two.

A gate driver 1026 drives SELi and SELi+1, and VB. The gate driver 1026 may include an address driver for providing address signals to the display array 1022. A data driver 1028 generates a programming data and drives VDATAj and VDATAj+1. A controller 1030 controls the drivers 1026 and 1028 to drive the pixels 1024 as described above.

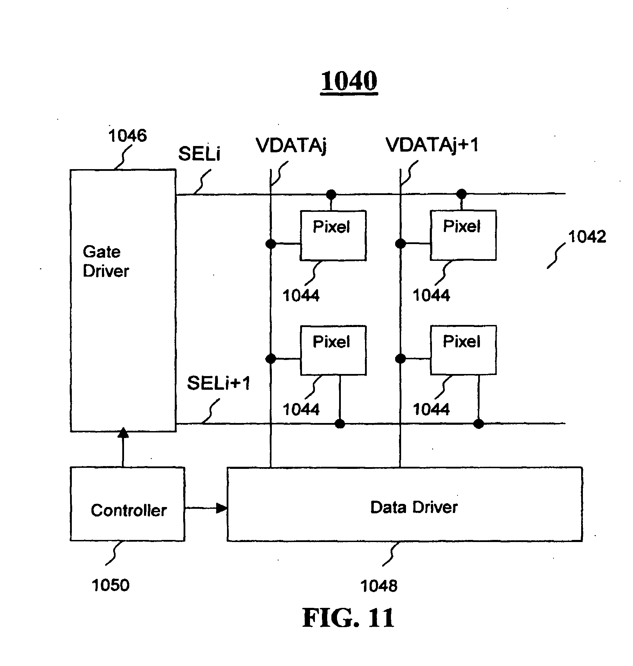

Figure 11 illustrates an example of a display system for the drive circuit of Figures 6 and 7. The display system 1040 of Figure 11 includes a display array 1042 having a plurality of pixels 1044. The pixel 1044 includes the drive circuit 164A of Figure 6 or 164B of Figure 7, and may be the pixel circuit 160A of Figure 6 or the pixel circuit 160B of Figure 7.

The display array 1042 is an active matrix light emitting display. In one example, the display array 1042 is an AMOLED display array. The display array 1042 may be a single color, multi-color or a fully color display, and may include one or more than one EL element (e.g., organic EL). The display array 1042 may be used in mobiles, PDAs, computer displays, or cellular phones.

Each of select lines SELi and SELi+1 corresponds to SEL of Figures 6 and 7. Each of data lines VDATAj and VDATAj+1 corresponds to VDATA of Figures 6 and 7. The pixels 1044 are arranged in rows and columns. The select line (SELi, SELi+1) is shared between common row pixels in the display array 1042. The data line (VDATAj, VDATAj+1) is shared between common column pixels in the display array 1042.

In Figure 11, four pixels 1044 are shown. However, the number of the pixels 1044 may vary in dependence upon the system design, and does not limited to four. In Figure 11, two select lines and two data lines are shown. However, the number of the select lines and the data lines may vary in dependence upon the system design, and does not limited to two.

A gate driver 1046 drives SELi and SELi+1. The gate driver 1046 may be an address driver for providing address signals to the address lines (e.g., select lines). A data driver 1048 generates a programming data and drives VDATAj and VDATAj+1. A controller 1040 controls the drivers 1046 and 1048 to drive the pixels 1044 as described above.

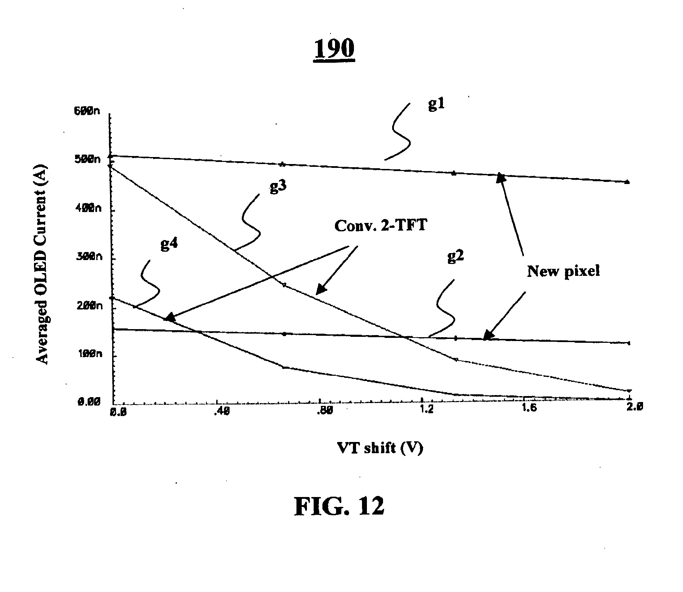

Figure 12 illustrates simulation results for the pixel circuit 100 of Figure 1. In Figure 12, "g1" represents the current of the pixel circuit 100 presented in Figure 1 for different shifts in the threshold voltage of the drive transistor 106 and initial current of 500 nA; "g2" represents the current of the pixel circuit 100 for different shifts in the threshold voltage of the drive transistor 106and initial current of 150 nA. In Figure 12, "g3" represents the current of a conventional 2-TFT pixel circuit for different shifts in the threshold voltage of a drive transistor and initial current of 500 nA; "g4" represents the current of the conventional 2-TFT pixel circuit for different shifts in the threshold voltage of a drive transistor and initial current of 150 nA. It is obvious that the averaged pixel current is stable for the new driving scheme whereas it drops dramatically if the discharging transistor (e.g., 106 of Figure 1) is removed from the pixel circuit (conventional 2-TFT pixel circuit).

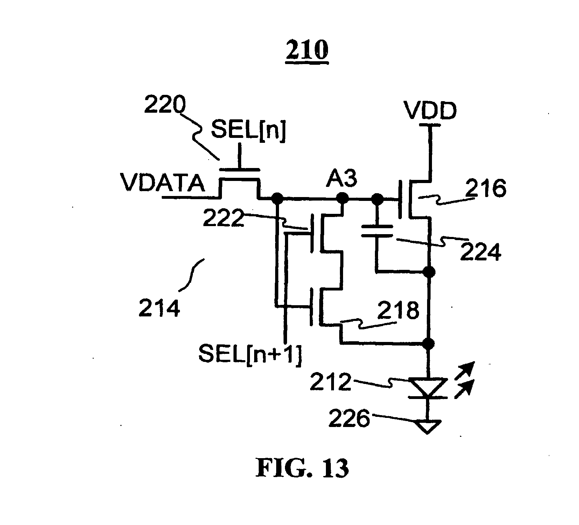

Figure 13 illustrates an example of a pixel circuit to which a pixel drive scheme in accordance with a further embodiment of the present invention. The pixel circuit 210 of Figure 13 includes an OLED 212 and a drive circuit 214 for driving the OLED 212. The drive circuit 214 includes a drive transistor 216, a discharging transistor 218, first and second switch transistors 220 and 222, and a storage capacitor 224.

The pixel circuit 210 is similar to the pixel circuit 190 of Figure 8. The drive circuit 214 is similar to the drive circuit 164 of Figures 5 and 8. The transistors 216, 218 and 220 correspond to the transistors 166, 168 and 170 of Figures 5 and 8, respectively. The transistors 216, 218, and 220 may be same or similar to the transistors 166, 168, and 170 of Figures 5 and 8. The transistor 222 may be same or similar to the transistor 172 of Figure 5 or the transistor 178 of Figure 8. In one example, each of the transistors 216, 218, 220, and 222 includes a gate terminal, a source terminal and a drain terminal. The storage capacitor 224 corresponds to the storage capacitor 174 of Figures 5 to 8. The storage capacitor 224 may be same or similar to the storage capacitor 174 of Figures 5 to 8. The OLED 212 corresponds to the OLED 192 of Figure 8. The OLED 212 may be same or similar to the OLED 192 of Figure 8.

The transistors 216, 218, 220, and 222 may be fabricated using amorphous silicon, nano/micro crystalline silicon, poly silicon, organic semiconductors technologies (e.g., organic TFT), NMOS/PMOS technology or CMOS technology (e.g., MOSFET).

In the pixel circuit 210, the drive transistor 216 is provided between VDD and one electrode (e.g., anode electrode) of the OLED 212. The switch transistor 222 and the discharging transistor 218 are connected in series between the gate terminal of the drive transistor 216 and the OLED 212. One terminal of the switch transistor 222 is connected to the gate terminal of the drive transistor at node A3. The gate terminal of the discharging transistor 218 is connected to node A3, The storage capacitor 224 is provided between node A3 and the OLED 212. The switch transistor 220 is provided between VDATA and node A3. The gate terminal of the switch transistor 220 is connected to a select line SEL[n]. The gate terminal of the switch transistor 222 is connected to a select line SEL [n+1]. The other electrode (e.g., cathode electrode) of the OLED 212 is connected to a power supply line (e.g., common ground) 226. In one example, SEL [n] is the address line of the nth row in a display array, and SEL[n+1] is the address line of the (n+1)th row in the display array.

The pixel circuit 210 provides constant averaged current over the frame time by adjusting the gate voltage of the drive transistor 216, as described below.

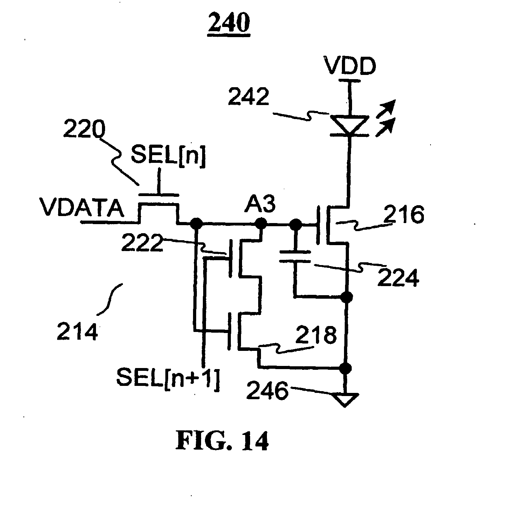

Figure 14 illustrates another example of a pixel circuit having the drive circuit 214 of Figure 13. The pixel circuit 240 of Figure 14 is similar to the pixel circuit 160 of Figure 5. The pixel circuit 240 includes an OLED 242. The OLED 242 may be same or similar to the OLED 162 of Figure 5. In the pixel circuit 240, the drive transistor 216 is provided between one electrode (e.g., cathode electrode) of the OLED 242 and a power supply line (e.g., common ground) 246. One terminal of the discharging transistor 218 and one terminal of the storage capacitor 224 are connected to the power supply line 246. The other electrode (e.g., anode electrode) of the OLED 242 is connected to VDD. The gate terminal of the switch transistor 220 is connected to the select line SEL[n]. The gate terminal of the switch transistor 222 is connected to the select line SEL [n+1].

The pixel circuit 240 provides constant averaged current over the frame time, in a manner similar to that of the pixel circuit 210 of Figure 13.

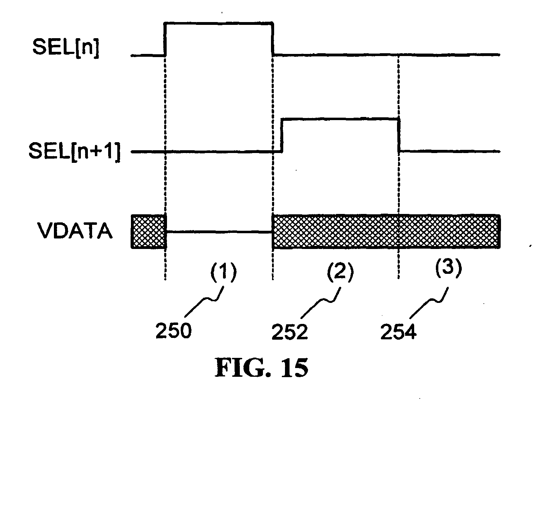

Figure 15 illustrates an example of method of driving a pixel circuit in accordance with an embodiment of the present invention. The waveforms of Figure 15 are applied to a pixel circuit (e.g., 210 of Figure 13, 240 of Figure 14) having the drive circuit 214 of Figures 13 and 14.

The operation cycles of Figure 15 include three operation cycles 250, 252 and 254. The operation cycle 250 forms a programming cycle, the operation cycle 252 forms a compensation cycle, and the operation cycle 254 forms a driving cycle. Referring to Figures 13 to 15, during the programming cycle 250, node A3 is charged to a programming voltage through the switch transistor 220 while SEL[n] is high. During the second operating cycle 252 SEL[n+1] goes to a high voltage. SEL[n] is disenabled (or deactivated). Node A3 is discharged through the discharging transistor 218. During the third operating cycle 254, SEL[n] and SEL[n+1] are disenabled. Since the drive transistor 216 and the discharging transistor 218 have the same bias condition, they experience the same threshold voltage shift. Considering that the discharge time is a function of transconductance of the discharging transistor 218, the discharged voltage decreases as the threshold voltage of the drive transistor 216/the discharging transistor 218 increases. Therefore, the gate voltage of the drive transistor 216 is adjusted accordingly.

In addition, in the pixel 240 of Figure 14, an increase in the OLED voltage for the OLED 242 results in higher gate voltage. Thus, the pixel current remains constant.

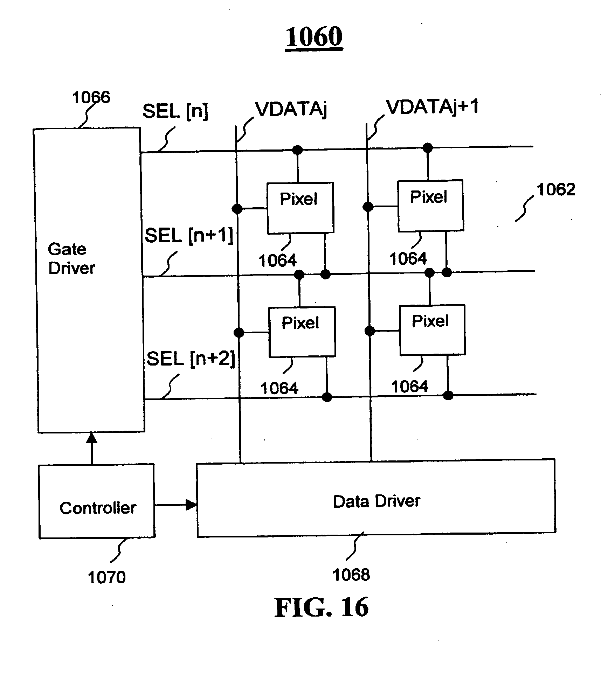

Figure 16 illustrates an example of a display system for the drive circuit of Figures 13 and 14. The display system 1060 of Figure 16 includes a display array 1062 having a plurality of pixels 1064. The pixel 1064 includes the drive circuit 214 of Figures 13 and 14, and may be the pixel circuit 210 of Figure 13 or the pixel circuit 240 of Figure 14.

The display array 1062 is an active matrix light emitting display. In one example, the display array 1062 is an AMOLED display array. The display array 1062 may be a single color, multi-color or a fully color display, and may include one or more than one EL element (e.g., organic EL). The display array 1062 may be used in mobiles, PDAs, computer displays, or cellular phones.

SEL[k] (k=n, n+1, n+2) is an address line for the kth row. VDATA1 (1=j, j+1) is a data line and corresponds to VDATA of Figures 13 and 14. The pixels 1064 are arranged in rows and columns. The select line SEL[k] is shared between common row pixels in the display array 1062. The data line VDATA1 is shared between common column pixels in the display array 1062.

In Figure 16, four pixels 1064 are shown. However, the number of the pixels 1064 may vary in dependence upon the system design, and does not limited to four. In Figure 16, three address lines and two data lines are shown. However, the number of the address lines and the data lines may vary in dependence upon the system design.

A gate driver 1066 drives SEL[k]. The gate driver 1066 may be an address driver for providing address signals to the address lines (e.g., select lines). A data driver 1068 generates a programming data and drives VDATA1. A controller 1070 controls the drivers 1066 and 1068 to drive the pixels 1064 as described above.

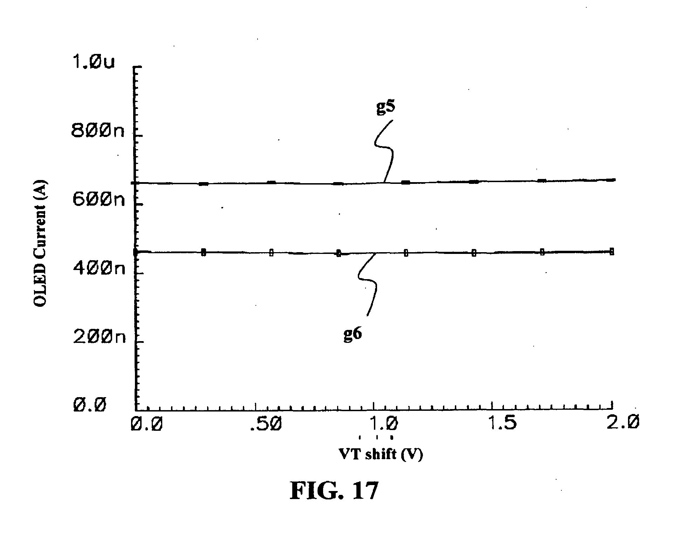

Figure 17 illustrates the simulation results for the pixel circuit 160 of Figure 5. In Figure 17, "g5" represents the current of the pixel circuit 160 presented in Figure 5 for different shifts in the threshold voltage of the drive transistor 166 and initial current of 630 nA; "g6" represents the current of the pixel circuit 160 for different shifts in the threshold voltage of the drive transistor 166 and initial current of 430 nA. It is seen that the pixel current is highly stable even after a 2-V shift in the threshold voltage of the drive transistor. Since the pixel circuit 210 of Figure 13 is similar to the pixel circuit 160 of Figure 15, it is apparent to one of ordinary skill in the art that the pixel current of the pixel circuit 210 will be also stable.

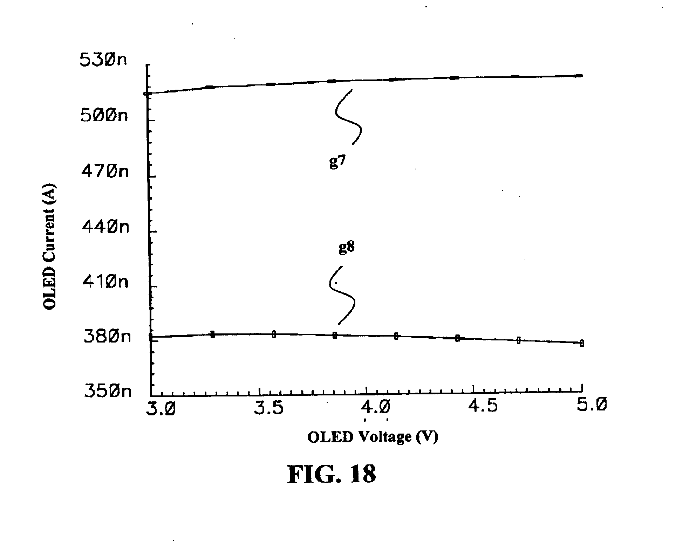

Figure 18 illustrates the simulation results for the pixel circuit 160 of Figure 5. In Figure 18, "g7" represents the current of the pixel circuit 160 presented in Figure 5 for different OLED voltages of the drive transistor 166 and initial current of 515 nA; "g8" represents the current of the pixel circuit 160 for different OLED voltages of the drive transistor 166 and initial current of 380 nA. It is seen that the pixel current is highly stable even after a 2-V shift in the voltage of the OLED. Since the pixel circuit 210 of Figure 13 is similar to the pixel circuit 160 of Figure 15, it is apparent to one of ordinary skill in the art that the pixel current of the pixel circuit 210 will be also stable.

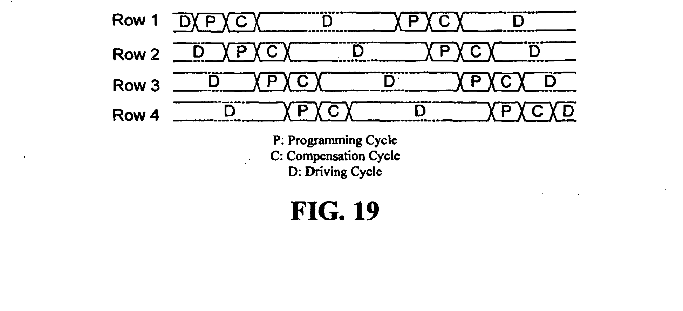

Figure 19 is a diagram showing programming and driving cycles for driving the display arrays 1062 of Figure 16. In Figure 16, each of ROW j (j=1, 2, 3, 4) represents the jth row of the display array 1062. In Figure 19, "P" represents a programming cycle; "C" represents a compensation cycle; and "D" represents a driving cycle. The programming cycle P at the jth Row overlaps with the driving cycle D at the (j+1)th Row. The compensation cycle C at the jth Row overlaps with the programming cycle P at the (j+1)th Row. The driving cycle D at the jth Row overlaps with the compensation cycle C at the (j+1)th Row.

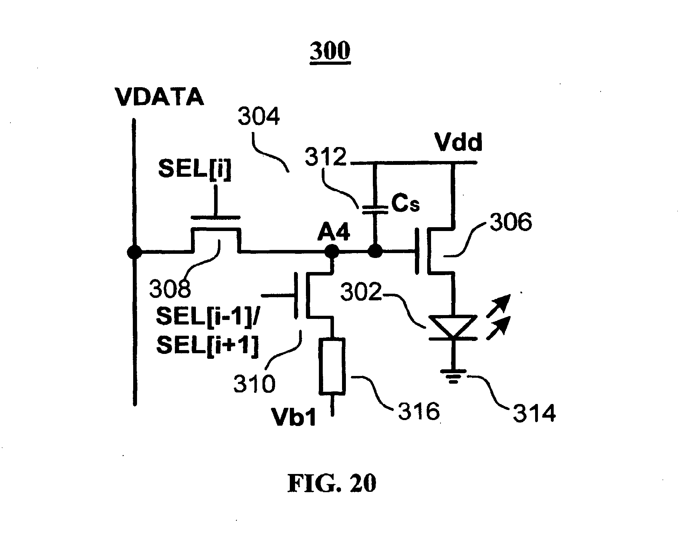

Figure 20 illustrates an example of a pixel circuit to which a pixel drive scheme in accordance with an illustrative example for understanding the present invention is applied. The pixel circuit 300 of Figure 20 includes an OLED 302 and a drive circuit 304 for driving the OLED 302. The drive circuit 304 includes a drive transistor 306, a switch transistor 308, a discharging transistor 310, and a storage capacitor 312. The OLED 302 includes, for example, an anode electrode, a cathode electrode and an emission layer between the anode electrode and the cathode electrode.

In one example, the transistors 306, 308 and 310 are n-type transistors. In another example, the transistors 306, 308 and 310 are p-type transistors or a combination of n-type and p-type transistors. In one example, each of the transistors 306, 308 and 310 includes a gate terminal, a source terminal and a drain terminal. The transistors 306,308 and 310 may be fabricated using amorphous silicon, nano/micro crystalline silicon, poly silicon, organic semiconductors technologies (e.g., organic TFT), NMOS/PMOS technology or CMOS technology (e.g., MOSFET).

The drive transistor 306 is provided between a voltage supply line Vdd and the OLED 302. One terminal (e.g., source) of the drive transistor 306 is connected to Vdd. The other terminal (e.g., drain) of the drive transistor 306 is connected to one electrode (e.g., anode electrode) of the OLED 302. The other electrode (e.g., cathode electrode) of the OLED 302 is connected to a power supply line (e.g., common ground) 314. One terminal of the storage capacitor 312 is connected to the gate terminal of the drive transistor 306 at node A4. The other terminal of the storage capacitor 312 is connected to Vdd. The gate terminal of the switch transistor 308 is connected to a select line SEL [i]. One terminal of the switch transistor 308 is connected to a data line VDATA. The other terminal of the switch transistor 308 is connected to node A4. The gate terminal of the discharging transistor 310 is connected to a select line SEL [i-1] or SEL[i+l]. In one example, the select line SEL[m] (m=i-1, i, i+1) is an address line for the mth row in a display array. One terminal of the discharging transistor 310 is connected to node A4. The other terminal of the discharging transistor 310 is connected to a sensor 316. In one example, each pixel includes the sensor 316. In another example, the sensor 316 is shared by a plurality of pixel circuits.

The sensor 316 includes a sensing terminal and a bias terminal Vb1. The sensing terminal of the sensor 316 is connected to the discharging transistor 310. The bias terminal Vb1 may be connected, for example, but not limited to, ground, Vdd or the one terminal (e.g., source) of the drive transistor 306. The sensor 316 detects energy transfer from the pixel circuit. The sensor 316 has a conductance that varies in dependence upon the sensing result. The emitted light or thermal energy by the pixel absorbed by the sensor 316 and so the carrier density of the sensor changes. The sensor 316 provides feedback by, for example, but not limited to, optical, thermal or other means of transduction. The sensor 316 may be, but not limited to, an optical sensor or a thermal sensor. As described below, node A4 is discharged in dependence upon the conductance of the sensor 316.

The drive circuit 304 is used to implement programming, compensating/calibrating and driving of the pixel circuit. The pixel circuit 300 provides constant luminance over the lifetime of its display by adjusting the gate voltage of the drive transistor 306.

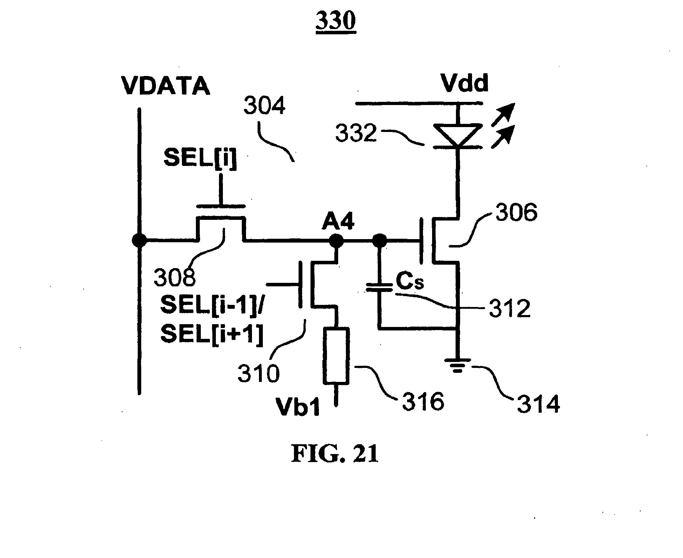

Figure 21 illustrates anther example of a pixel circuit having the drive circuit 304 of Figure 20. The pixel circuit 330 of Figure 21 is similar to the pixel circuit 300 of Figure 20. The pixel circuit 330 includes an OLED 332. The OLED 332 may be same or similar to the OLED 302 of Figure 20. In the pixel circuit 330, one terminal (e.g., drain) of the drive transistor 306 is connected to one electrode (e.g., cathode electrode) of the OLED 332, and the other terminal (e.g., source) of the drive transistor 306 is connected to a power supply line (e.g., common ground) 334. In addition, one terminal of the storage capacitor 312 is connected to node A4, and the other terminal of the storage capacitor 312 is connected to the power supply line 334. The pixel circuit 330 provides constant luminance over the lifetime of its display, in a manner similar to that of the pixel circuit 300 of Figure 20.

Referring to Figures 20 and 21, the aging of the drive transistor 306 and the OLED 302/332 in the pixel circuit are compensated in two different ways: in-pixel compensation and of-panel calibration.

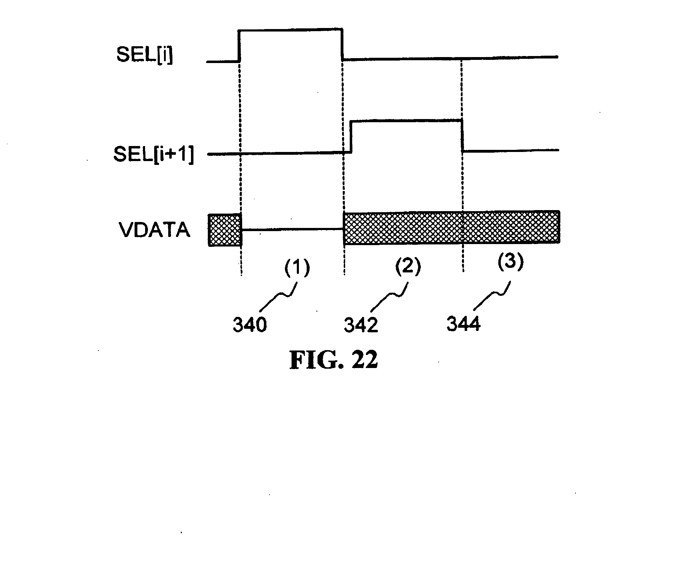

In-pixel compensation is descried in detail. Figure 22 illustrates an example of a method of driving a pixel circuit. By applying the waveforms of Figure 22 to a pixel having the drive circuit 304 of Figures 20 and 21, the in-pixel compensation is implemented.

The operation cycles of Figure 22 include three operation cycles 340, 342 and 344. The operation cycle 340 is a programming cycle of the ith row and is a driving cycle for the (i+1)th row. The operation cycle 342 is a compensation cycle for the ith row and is a programming cycle of the (i+1)th row. The operation cycle 344 is a driving cycle for the ith row and is a compensation cycle for the (i+1)th row.] Referring to Figures 20 to 22, during the programming cycle 340 for the ith row of a display, node A4 of the pixel circuit in the ith row is charged to a programming voltage through the switch transistor 308 while the select line SEL[i] is high. During the programming cycle 342 for the (i+1)th row, SEL[i+1] goes high, and the voltage stored at node A4 changes based on the conductance of the sensor 316. During the driving cycle 344 of the ith row, the current of the drive transistor 306 controls the OLED luminance.

The amount of the discharged voltage at node A4 depends on the conductance of the sensor 316. The sensor 316 is controlled by the OLED luminance or temperature. Thus, the amount of the discharged voltage reduces as the pixel ages. This results in constant luminance over the lifetime of the pixel circuit.

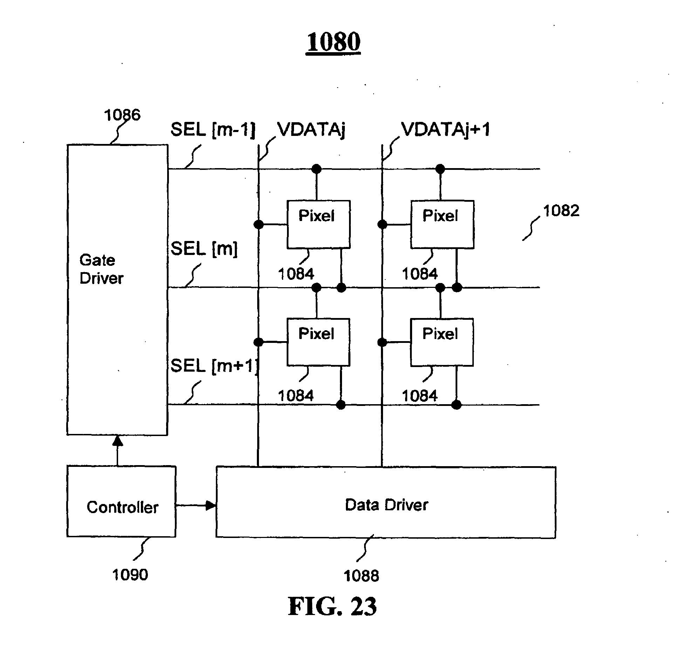

Figure 23 illustrates an example of a display system for the drive circuit 304 of Figures 20 and 21. The display system 1080 of Figure 23 includes a display array 1082 having a plurality of pixels 1084. The pixel 1084 includes the drive circuit 304 of Figures 20 and 21, and may be the pixel circuit 300 of Figure 20 or the pixel circuit 330 of Figure 21.

The display array 1082 is an active matrix light emitting display. In one example, the display array 1082 is an AMOLED display array. The display array 1082 may be a single color, multi-color or a fully color display, and may include one or more than one electroluminescence (EL) element (e.g., organic EL). The display array 1082 may be used in mobiles, personal digital assistants (PDAs), computer displays, or cellular phones.

SEL[i] (i= m-1, m, m+1) in Figure 23 is an address line for the ith row. VDATAn (n=j, j+1) in Figure 23 is a data line for the nth column The address line SEL[i] correspond to the select line SEL[i] of Figures 20 and 21. The data line VDATAn corresponds to VDATA of Figures 20 and 21.

A gate driver 1086 includes an address driver for providing an address signal to each address line to drive them. A data driver 1088 generates a programming data and drives the data line. A controller 1090 controls the drivers 1086 and 1088 to drive the pixels 1084 and implement the in-pixel compensation as described above.

In Figure 23, four pixels 1084 are shown. However, the number of the pixels 1084 may vary in dependence upon the system design, and does not limited to four. In Figure 23, three address lines and two data lines are shown. However, the number of the select lines and the data lines may vary in dependence upon the system design.

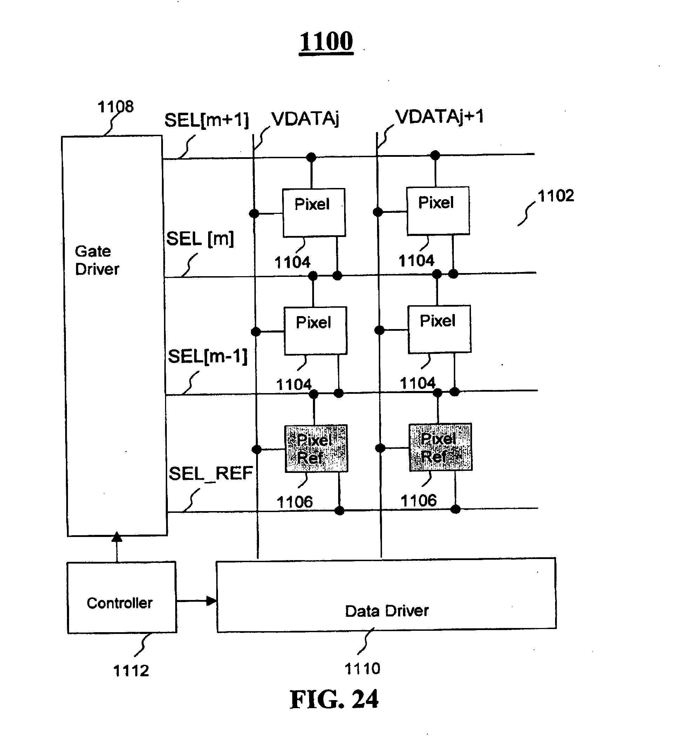

In Figure 23, each of the pixels 1084 includes the sensor 316 of Figures 20 and 21. In another example, the display array 1080 may include one or more than one reference pixel having the sensor 316, as shown in Figure 24.

Figure 24 illustrates another example of a display system for the drive circuit 304 of Figures 20 and 21. The display system 1100 of Figure 24 includes a display array 1102 having a plurality of pixels 1104 and one or more than one reference pixels 1106. The reference pixel 1106 includes the drive circuit 304 of Figures 20 and 21, and may be the pixel circuit 300 of Figure 20 or the pixel circuit 330 of Figure 21. In Figure 24, two reference pixels 1106 are shown. However, the number of the pixels 1084 may vary in dependence upon the system design, and does not limited to two. The pixel 1104 includes an OLED and a drive transistor for driving the OLED, and does not include the sensor 316 of Figures 20 and 21. SEL_REF is a select line for selecting the discharging transistors in the array of the reference pixels 1106.

A gate driver 1108 drives the address lines and the select line SEL_REF. The gate driver 1108 may be same or similar to the gate driver 1108 of Figure 24. A data driver 1110 drives the data lines. The data driver 1110 may be same or similar to the data driver 1088 of Figure 23. A controller 1112 controls the drivers 1108 and 1110.

The reference pixels of Figures 23 and 24 (1084 of Figure 23, 1106 of Figure 24) may be operated to provide aging knowledge for an of-panel algorithm in which the programming voltage is calibrated at the controller (1090 of Figure 23, 1112 of Figure 24) or driver side (1088 of Figure 23, 1110 of Figure 24) as described below.

Of-panel calibration is descried in detail. Referring to Figure 21, the of-panel calibration is implemented by extracting the aging of the pixel circuit by reading back the sensor 316, and calibrating the programming voltage. The of-panel calibration compensates for the pixel aging including the threshold Vt shift and OLED degradation.

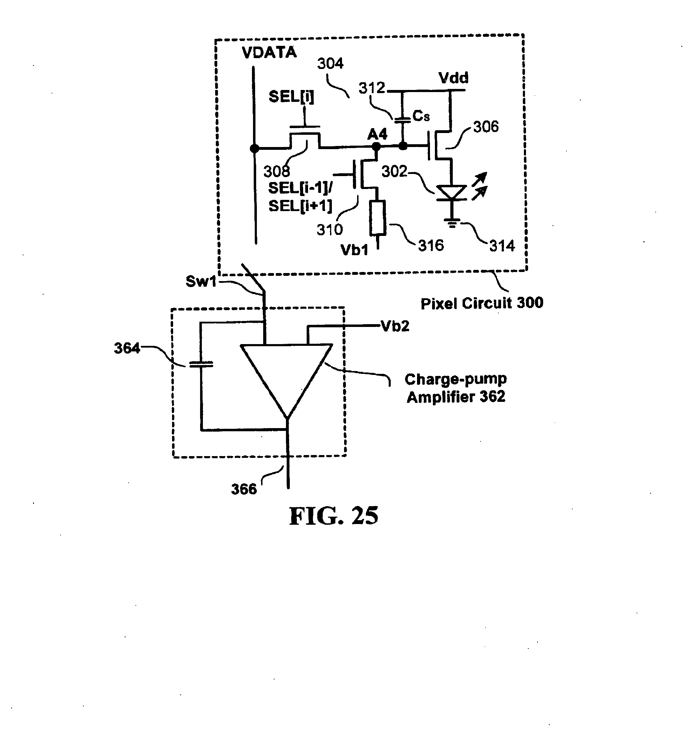

Figure 25 illustrates an example of a pixel system. The pixel system of Figure 25 includes a read back circuit 360. The read back circuit 360 includes a charge-pump amplifier 362 and a capacitor 364. One terminal of the charge-pump amplifier 362 is connectable to the data line VDATA via a switch SW1. The other terminal of the charge-pump amplifier 362 is connected to a bias voltage Vb2. The charge-pump amplifier 362 reads back the voltage discharged from the node A4 via the switch SW1.

The output 366 of the charge pump amplifier 362 varies in dependent upon the voltage at node A4. The time depending characteristics of the pixel circuit is readable from node A4 via the charge-pump amplifier 362.

In Figure 25, one read back circuit 360 and one switch SW 1 are illustrated for one pixel circuit. However, the read back circuit 360 and the switch SW1 may be provided for a group of pixel circuits (e.g., pixel circuits in a column). In Figure 25, the read back circuit 360 and the switch SW 1 are provided to the pixel circuit 300. In another example, the read back circuit 360 and the switch SW1 are applied to the pixel circuit 330 of Figure 21.

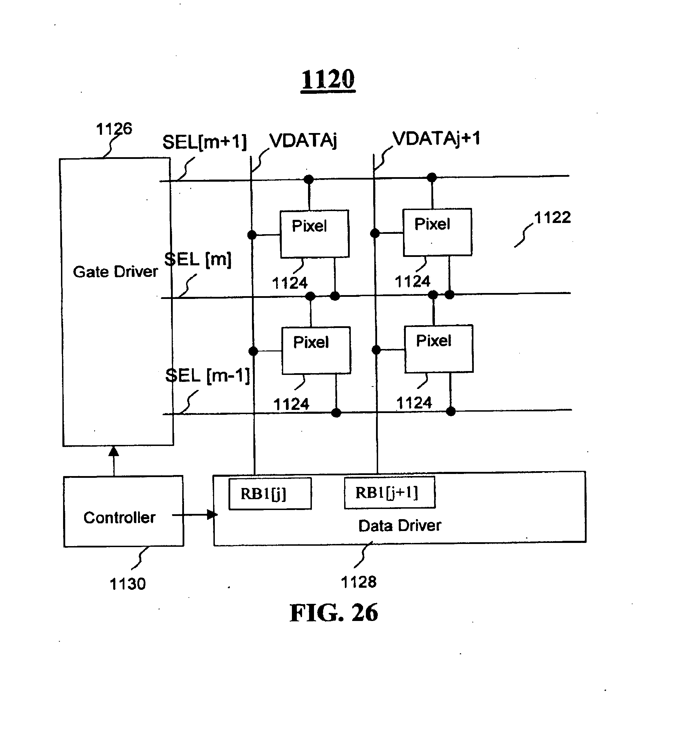

Figure 26 illustrates an example of a display system having the read back circuit 360 of Figure 25. The display system 1120 of Figure 26 includes a display array 1122 having a plurality of pixels 1124. The pixel 1124 includes the drive circuit 304 of Figures 20 and 21, and may be the pixel circuit 300 of Figure 20 or the pixel circuit 330 of Figure 21. The pixel 1124 may be same or similar to the pixel 1084 of Figure 23 or 1106 of Figure 24.

In Figure 26, four pixels 1124 are shown. However, the number of the pixels 1124 may vary in dependence upon the system design, and does not limited to four. In Figure 26, three address lines and two data lines are shown. However, the number of the select lines and the data lines may vary in dependence upon the system design.

For each column, a read back circuit RB1[n] (n=j, j+1) and a switch SW1[n] (not shown) are provided. The read back circuit RB 1[n] may include the SW1[n]. The read back circuit RB1[n] and the switch SW1[n] correspond to the read back 360 and the switch SW1 of Figure 25, respectively. In the description below, the terms RB1 and RB1[n] may be used interchangeably, and RB 1 may refer to the read back circuit 360 of Figure 25 for a certain row.

The display array 1122 is an active matrix light emitting display. In one example, the display array 1122 is an AMOLED display array. The display array 1122 may be a single color, multi-color or a fully color display, and may include one or more than one electroluminescence (EL) element (e.g., organic EL). The display array 1122 may be used in mobiles, personal digital assistants (PDAs), computer displays, or cellular phones.

A gate driver 1126 includes an address driver for driving the address lines. The gate driver 1126 may be same or similar to the gate driver 1086 of Figure 23 or the gate driver 1108 of Figure 24. A data driver 1128 generates a programming data and drives the data lines. The data driver 1128 includes a circuit for calculating the programming data based on the output of the corresponding read back circuit RB1[n]. A controller 1130 controls the drivers 1126 and 1128 to drive the pixels 1124 as described above. The controller 1130 controls the switch SW 1[n] to turn on or off so that the RB1[n] is connected to the corresponding data line VDATAn.

The pixels 1124 are operated to provide aging knowledge for the of-panel algorithm in which the programming voltage is calibrated at the controller 1130 or driver side 1128 according to the output voltage of the read back circuit RB1. A simple calibration can be scaling in which the programming voltage is scaled up by the change in the output voltage of the read back circuit RB1.

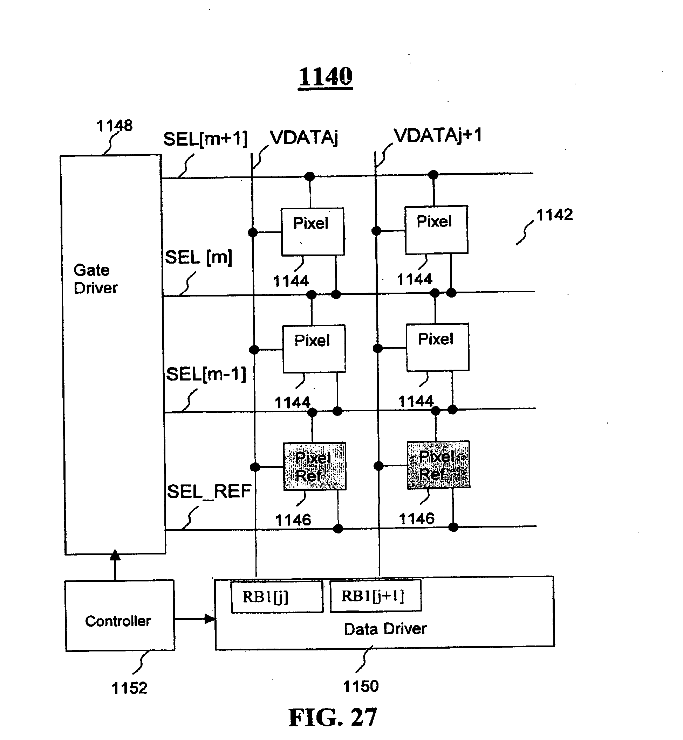

In Figure 26, each of the pixels 1124 includes the sensor 316 of Figures 20 and 21. In another example, the display array 1120 may include one or more than one reference pixel having the sensor 316, as shown in Figure 27.

Figure 27 illustrates another example of a display system having the read back circuit of Figure 25. The display system 1140 of Figure 27 includes a display array 1142 having a plurality of pixels 1144 and one or more than one reference pixels 1146. The reference pixel 1146 includes the drive circuit 304 of Figures 20 and 21, and may be the pixel circuit 300 of Figure 20 or the pixel circuit 330 of Figure 21. In Figure 27, two reference pixels 1146 are shown. However, the number of the pixels 1084 may vary in dependence upon the system design, and does not limited to two. The pixel 1144 includes an OLED and a drive transistor for driving the OLED, and does not include the sensor 316 of Figures 20 and 21. SEL_REF is a select line for selecting the discharging transistors in the array of the reference pixels 1146.

A gate driver 1148 drives the address lines and the select line SEL_REF. The gate driver 1148 may be same or similar to the gate driver 1126 of Figure 26. A data driver 1150 generates a programming data, calibrates the programming data and drives the data lines. The data driver 1150 may be same or similar to the data driver 1128 of Figure 26. A controller 1152 controls the drivers 1148 and 1150.

The reference pixels 1146 are operated to provide aging knowledge for the of-panel algorithm in which the programming voltage is calibrated at the controller 1152 or driver side 1150 according to the output voltage of the read back circuit RB1. A simple calibration can be scaling in which the programming voltage is scaled up by the change in the output voltage of the read back circuit RB1.

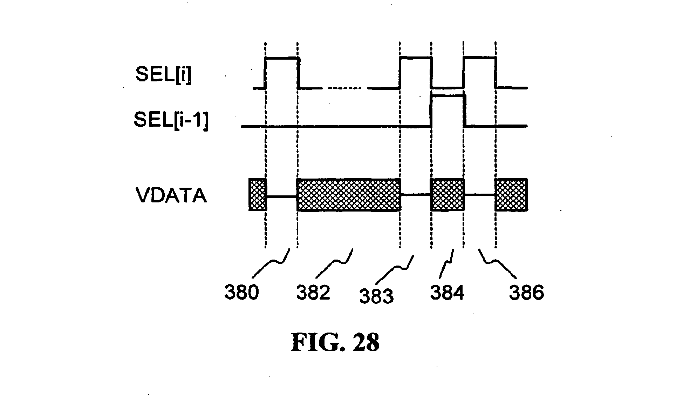

Figure 28 illustrates an example of a method of driving a pixel circuit. The display system 1120 of Figure 26 and the display system 1140 of Figure 27 are capable of operating according to the waveforms of Figure 28. By applying the waveforms of Figure 28 to the display system having the read back circuit (e.g., 360 of Figure 3, RB1 of Figures 26 and 27), the of panel calibration is implemented.

The operation cycles of Figure 28 include operation cycles 380, 382, 383, 384, and 386. The operation cycle 380 is a programming cycle for the ith row. The operation cycle 382 is a driving cycle for the ith row. The driving cycle of each row is independent of the other rows. The operation cycle 383 is an initialization cycle for the ith row. The operation cycle 384 is an integration cycle for the ith row. The operation cycle 386 is a read back cycle for the ith row.

Referring to Figures 25 to 28, during the programming cycle 380 for the ith row, node A4 of the pixel circuit in the ith row is charged to a programming voltage through the switch transistor 308 while the select line SEL[i] is high. During the programming cycle 380 for the ith row, node A4 is charged to a calibrated programming voltage. During the driving cycle 382 for the ith row, the OLED luminance is controlled by the driver transistor 306. During the initialization cycle 383 for the ith row, node A4 is charged to a bias voltage. During the integration cycle 384 for the ith row, the SEL[i-1] is high and so the voltage at node A4 is discharged through the sensor 316. During the read back cycle 386, the change in the voltage at node A4 is read back to be used for calibration (e.g. scaling the programming voltage).

At the beginning of the read back cycle 384, the switch SW1 of the read back circuit RB1 is on, and the data line VDATA is charged to Vb2. Also the capacitor 364 is charged to a voltage, Vpre, as a result of leakage contributed from all the pixels connected to the date line VDATA. Then the select line SEL[i] goes high and so the discharged voltage Vdisch is developed across the capacitor 364. The difference between the two extracted voltages (Vpre and Vdisch) are used to calculate the pixel aging.

The sensor 316 can be OFF most of the time and be ON just for the integration cycle 384. Thus, the sensor 316 ages very slightly. In addition, the sensor 316 can be biased correctly to suppress its degradation significantly

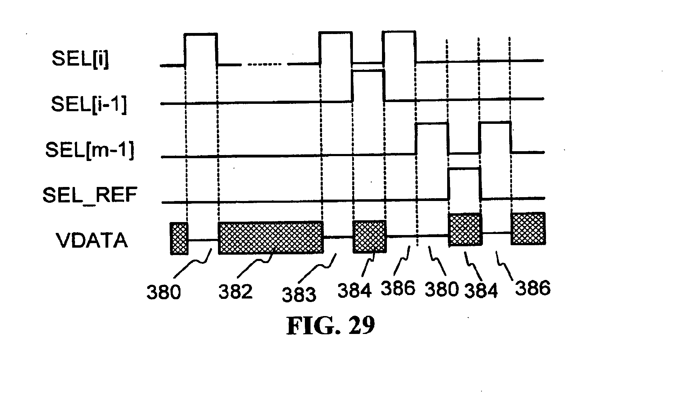

In addition, this method can be used for extracting the aging of the sensor 316. Figure 29 illustrates an example of a method of extracting the aging of the sensor 316. The extracted voltages of the sensors for a dark pixel and a dark reference pixel can be used to find out the aging of the sensor 316. For example, the display system 1140 of Figure 27 is capable of operating according to the waveforms of Figure 29.

The operation cycles of Figure 29 include operation cycles 380, 382, 383, 384, and 386. The operation cycle 380 is a programming cycle for the ith row. The operation cycle 382 is a driving cycle for the ith row. The operation cycle 383 is an initialization cycle for the ith row. The operation cycle 384 is an integration cycle for the ith row. The operation cycle 386 is a read back cycle for the ith row. The operation cycle 380 (the second occurrence) is an initialization for a reference row. The operation cycle 384 (the second occurrence) is an integration cycle for the reference row. The operation cycle 386 (the second occurrence) is a read back cycle (extraction) for the reference row.

The reference row includes one or more reference pixels (e.g., 1146 of Figure 27), and is located in the (m-1)th row. SEL_REF is a select line for selecting the discharging transistors (e.g., 310 of Figure 25) in the reference pixels in the reference row.

Referring to Figures 25, 27 and 29, to extract the aging of the sensor 316, a normal pixel circuit (e.g., 1144) is OFF. The difference between the extracted voltage via the output 316 from the normal pixel and voltage extracted for the OFF state of the reference pixel (e.g., 1146) is extracted. The voltage for the OFF state of the reference pixel is extracted where the reference pixel is not under stress. This difference results in the extraction of the degradation of the sensor 316.

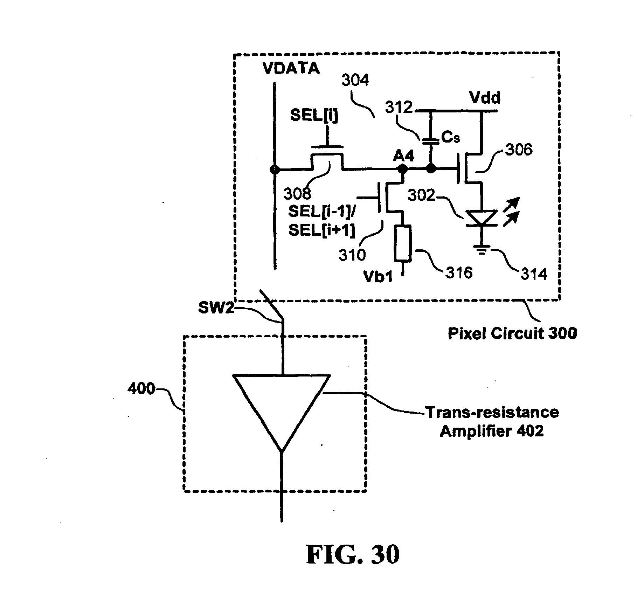

Figure 30 illustrates an example of a pixel system. The pixel system of Figure 30 includes a read back circuit 400. The read-back circuit 400 includes a trans-resistance amplifier 402. One terminal of the trans-resistance amplifier 402 is connectable to the data line VDATA via a switch SW2. The trans-resistance amplifier 402 reads back the voltage discharged from the node A4 via the switch SW2. The switch SW2 may be same or similar to the switch SW1 of Figure 25.

The output of the trans-resistance amplifier 402 varies in dependent upon the voltage at node A4. The time depending characteristics of the pixel circuit is readable from node A4 via the trans-resistance amplifier 402.

In Figure 30, one read back circuit 400 and one switch SW2 are illustrated for one pixel circuit. However, the read back circuit 400 and the switch SW2 may be provided for a group of pixel circuits (e.g., pixel circuits in a column). In Figure 30, the read back circuit 400 and the switch SW2 are provided to the pixel circuit 300. In another example, the read back circuit 400 and the switch SW2 are applied to the pixel circuit 330 of Figure 21.

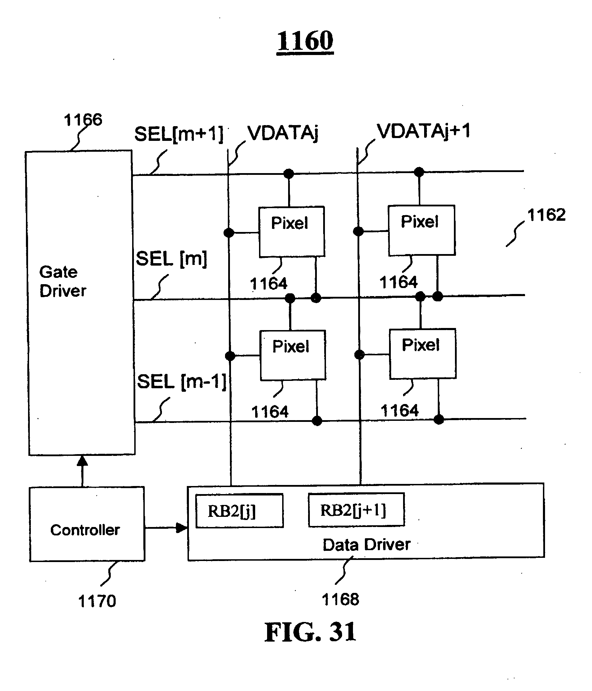

Figure 31 illustrates an example of a display system having the read back circuit 400 of Figures 30. The display system 1160 of Figure 31 includes a display array 1162 having a plurality of pixels 1164. The pixel 1164 includes the drive circuit 304 of Figures 20 and 21, and may be the pixel circuit 300 of Figure 20 or the pixel circuit 330 of Figure 21. The pixel 1164 may be same or similar to the pixel 1124 of Figure 26 or 1146 of Figure 27.

In Figure 31, four pixels 1164 are shown. However, the number of the pixels 1164 may vary in dependence upon the system design, and does not limited to four. In Figure 31, three address lines and two data lines are shown. However, the number of the select lines and the data lines may vary in dependence upon the system design.

For each column, a read back circuit RB2[n] (n=j, j+1) and a switch SW2[n] (not shown) are provided. The read back circuit RB2[n] may include the SW2[n]. The read back circuit RB2[n] and the switch SW2[n] correspond to the read back 400 and the switch SW2 of Figure 30, respectively. In the description below, the terms RB2 and RB2[n] may be used interchangeably, and RB2 may refer to the read back circuit 400 of Figure 30 for a certain row.

The display array 1162 is an active matrix light emitting display. In one example, the display array 1162 is an AMOLED display array. The display array 1162 may be a single color, multi-color or a fully color display, and may include one or more than one electroluminescence (EL) element (e.g., organic EL). The display array 1162 may be used in mobiles, personal digital assistants (PDAs), computer displays, or cellular phones.

A gate driver 1166 includes an address driver for driving the address lines. The gate driver 1166 may be same or similar to the gate driver 1126 of Figure 26 or the gate driver 1148 of Figure 27. A data driver 1168 generates a programming data and drives the data lines. The data driver 1168 includes a circuit for calculating the programming data based on the output of the corresponding read back circuit RB2[n]. A controller 1170 controls the drivers 1166 and 1168 to drive the pixels 1164 as described above. The controller 1170 controls the switch SW2[n] to turn on or off so that the RB2[n] is connected to the corresponding data line VDATAn.

The pixels 1164 are operated to provide aging knowledge for the of-panel algorithm in which the programming voltage is calibrated at the controller 1170 or driver side 1168 according to the output voltage of the read back circuit RB2. A simple calibration can be scaling in which the programming voltage is scaled up by the change in the output voltage of the read back circuit RB2.

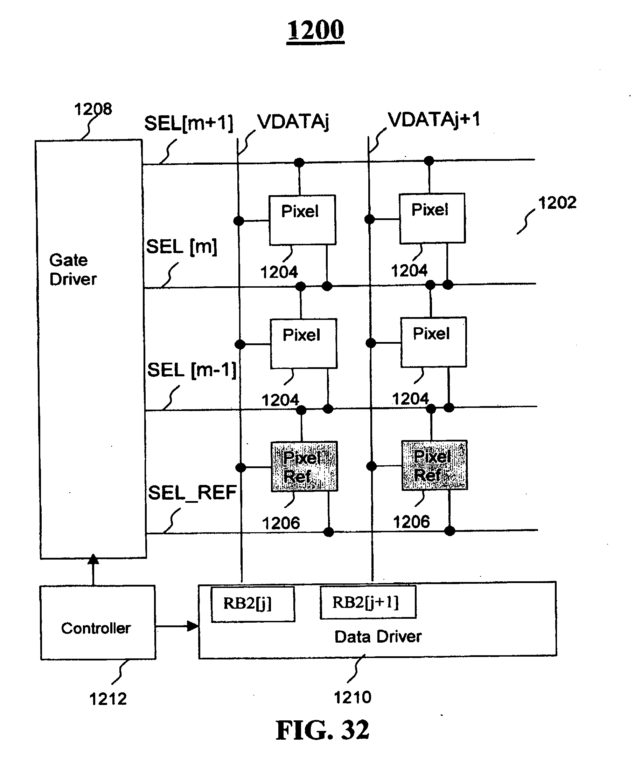

In Figure 31, each of the pixels 1164 includes the sensor 316 of Figures 20 and 21. In another example, the display array 1160 may include one or more than one reference pixel having the sensor 316, as shown in Figure 32.

Figure 32 illustrates another example of a display system having the read back circuit 400 of Figure 30. The display system 1200 of Figure 32 includes a display array 1202 having a plurality of pixels 1204 and one or more than one reference pixels 1206. The reference pixel 1206 includes the drive circuit 304 of Figures 20 and 21, and may be the pixel circuit 300 of Figure 20 or the pixel circuit 330 of Figure 21. In Figure 32, two reference pixels 1206 are shown. However, the number of the pixels 1204 may vary in dependence upon the system design, and does not limited to two. The pixel 1204 includes an OLED and a drive transistor for driving the OLED, and does not include the sensor 316 of Figures 20 and 21. SEL_REF is a select line for selecting the discharging transistors in the array of the reference pixels 1206.

A gate driver 1208 drives the address lines and the select line SEL_REF. The gate driver 1208 may be same or similar to the gate driver 1148 of Figure 27 or the gate driver 1166 of Figure 31. A data driver 1210 generates a programming data, calibrates the programming data and drives the data lines. The data driver 1210 may be same or similar to the data driver 1150 of Figure 27 or the data driver 1168 of Figure 32. A controller 1212 controls the drivers 1208 and 1210.

The reference pixels 1206 are operated to provide aging knowledge for the of panel algorithm in which the programming voltage is calibrated at the controller 1212 or driver side 1210 according to the output voltage of the read back circuit RB2. A simple calibration can be scaling in which the programming voltage is scaled up by the change in the output voltage of the read back circuit RB2.

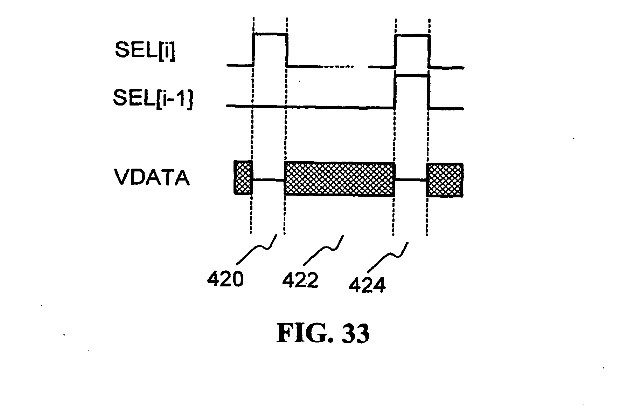

Figure 33 illustrates an example of a method of driving a pixel circuit. The display system 1160 of Figure 31 and the display system 1200 of Figure 32 are capable of operating according to the waveforms of Figure 33. By applying the waveforms of Figure 33 to the display system having the read back circuit (e.g., 400 of figure 30, RB2 of Figures 31 and 32), the of-panel calibration is implemented.

The operation cycles of Figure 33 include operation cycles 410,422 and 422 for a row. The operation cycle 420 is a programming cycle for the ith row. The operation cycle 422 is a driving cycle for the ith row. The operation cycle 424 is a read back (extraction) cycle for the ith row

Referring to Figure 30 to 33, during the programming cycle 420 for the ith row, node A4 of the pixel circuit in the ith row is charged to a programming voltage through the switch transistor 308 while the select line SEL[i] is high. During the driving cycle 422 for the ith row, the pixel luminance is controlled by the current of the drive transistor 306. During the extraction cycle 424 for the ith row, SEL [i] and SEL[i-1] are high and the current of the sensor 316 is monitored. The change in this current is amplified by the read back circuit RB2. This change is used to measured the luminance degradation in the pixel and compensate for it by calibrating the programming voltage (e.g. scaling the programming voltage).

At the beginning of the read-back cycle 424, the switch SW2 for the row that the algorithm chooses for calibration is ON while SEL[i] is low. Therefore, the leakage current is extracted as the output voltage of the trans-resistance amplifier 402. The selection of the row can be based on stress history, random, or sequential technique. Next, SEL[i] goes high and so the sensor current related to the luminance or temperature of the pixel is read back as the output voltage of the trans-resistance amplifier 402. Using the two extracted voltages for leakage current and sensor current, one can calculated the pixel aging.

The sensor 316 can be OFF most of the time and be ON just for the operation cycle 424. Thus, the sensor 316 ages very slightly. In addition, the sensor 316 can be biased correctly to suppress its degradation significantly

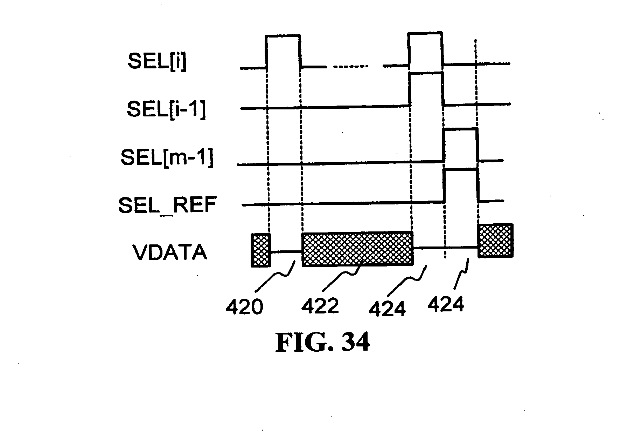

In addition, this method can be used for extracting the aging of the sensor 316. Figure 34 illustrates an example of a method of extracting the aging of the sensor 316 of Figure 30. For example, the display system 1200 of Figure 32 operates according to the waveforms of Figure 34.

The operation cycles of Figure 34 include operation cycles 420, 422 and 424. The operation cycle 420 (the first occurrence) is a programming cycle for the ith row. The operation cycle 422 is a driving cycle for the ith row. The operation cycle 424 (the first occurrence) is a read back (extraction) cycle for the ith row. The operation cycle 424 (the second occurrence) is a read back (extraction) cycle for a reference row.

The reference row includes one or more reference pixels (e.g., 1206 of Figure 32) and is located in the (m-1)th row. SEL_REF is a select line for selecting the discharging transistors (e.g., 310 of Figure 30) in the reference pixels in the reference row.

Referring to Figures 30, 32 and 34, to extract the aging of the sensor 316, a normal pixel circuit (e.g., 1204) is OFF. The difference between the extracted voltage via the output of the trans-resistance amplifier 402 from the normal pixel circuit and voltage extracted for the OFF state of the reference pixel (e.g., 1206) is extracted. The voltage for the OFF state of the reference pixel is extracted where the reference pixel is not under stress. This results in the extraction of the degradation of the sensor 316.

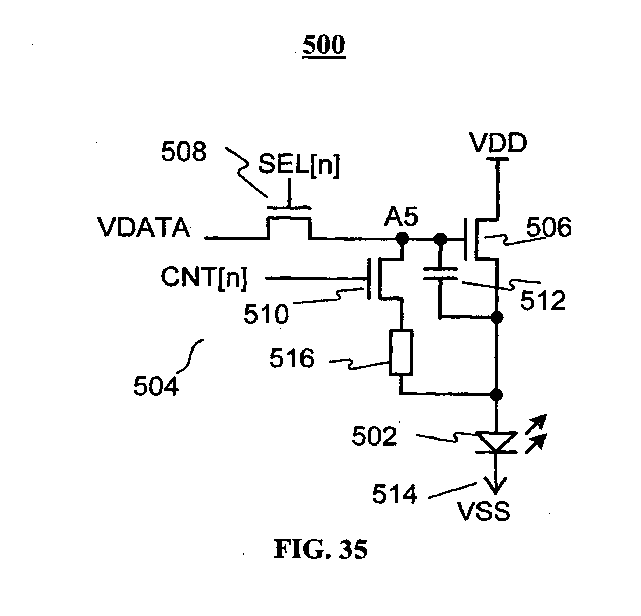

Figure 35 illustrates an example of a pixel circuit to which a pixel drive scheme. The pixel circuit 500 of Figure 35 includes an OLED 502 and a drive circuit 504 for driving the OLED 502. The drive circuit 504 includes a drive transistor 506, a switch transistor 508, a discharging transistor 510, an adjusting circuit 510, and a storage capacitor 512.

The OLED 502 may be same or similar to the OLED 212 of Figure 13 or the OLED 302 of Figure 20. The capacitor 512 may be same or similar to the capacitor 224 of Figure 13 or the capacitor 312 of Figure 20. The transistors 506, 508 and 510 may be same or similar to the transistors 206, 220, and 222 of Figure 13 or the transistors 306, 308 and 310 of Figure 20. In one example, each of the transistors 506, 508 and 510 includes a gate terminal, a source terminal and a drain terminal.

The drive transistor 506 is provided between a voltage supply line VDD and the OLED 502. One terminal (e.g., drain) of the drive transistor 506 is connected to VDD. The other terminal (e.g., source) of the drive transistor 506 is connected to one electrode (e.g., anode electrode) of the OLED 502. The other electrode (e.g., cathode electrode) of the OLED 502 is connected to a power supply line VSS (e.g., common ground) 514. One terminal of the storage capacitor 512 is connected to the gate terminal of the drive transistor 506 at node A5. The other terminal of the storage capacitor 512 is connected to the OLED 502. The gate terminal of the switch transistor 508 is connected to a select line SEL [n]. One terminal of the switch transistor 508 is connected to data line VDATA. The other terminal of the switch transistor 508 is connected to node A5. The gate terminal of the transistor 510 is connected to a control line CNT[n]. In one example, n represents the nth row in a display array. One terminal of the transistor 510 is connected to node A5. The other terminal of the transistor 510 is connected to one terminal of the adjusting circuit 516. The other terminal of the adjusting circuit 516 is connected to the OLED 502.

The adjusting circuit 516 is provided to adjust the voltage of A5 with the discharging transistor 510 since its resistance changes based on the pixel aging. In one example, the adjusting circuit 516 is the transistor 218 of Figure 13. In another example, the adjusting circuit 516 is the sensor 316 of Figure 20.

To improve the shift in the threshold voltage of the drive transistor 506, the pixel circuit is turned off for a portion of frame time.

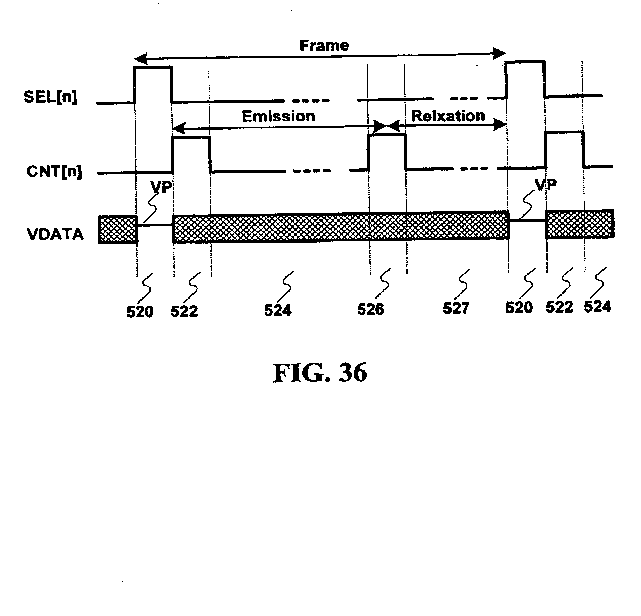

Figure 36 illustrates an example of a method of driving a pixel circuit. The waveforms of Figure 36 are applied to the pixel circuit of Figure 35. The operation cycles for the pixel circuit 500 include a programming cycle 520, a discharge cycle 522, an emission cycle 524, a reset cycle 526, and a relaxation cycle 527.

During the programming cycle 520, node A5 is charged to a programming voltage VP. During the discharge cycle 522, CNT[n] goes high, and the voltage at node A5 is discharge partially to compensate for the aging of the pixel. During the emission cycle 524, SEL[n] and CNT[n] go low. The OLED 502 is controlled by the drive transistor 506 during the emission cycle 524. During the reset cycle 526, the CNT[n] goes to a high voltage so as to discharge the voltage at node A5 completely during the reset cycle 526. During the relaxation cycle 527, the drive transistor 506 is not under stress and recovers from the emission 524. Therefore, the aging of the drive transistor 506 is reduced significantly.

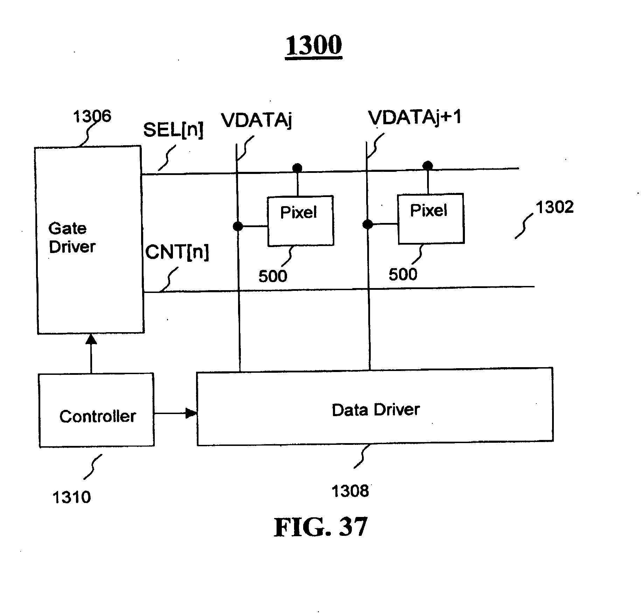

Figure 37 illustrates an example of a display system including the pixel circuit of Figure 35. The display system 1300 of Figure 37 includes a display array 1302 having a plurality of pixels 500. The display array 1302 is an active matrix light emitting display. In one example, the display array 1302 is an AMOLED display array. The pixels 500 are arranged in rows and columns. In Figure 37, two pixels 500 for the nth row are shown. The display array 1302 may include more than two pixels.

The display array 1302 may be a single color, multi-color or a fully color display, and may include one or more than one electroluminescence (EL) element (e.g., organic EL). The display array 1302 may be used in mobiles, personal digital assistants (PDAs), computer displays, or cellular phones.

Address line SEL[n] is proved to the nth row. Control line CNT[n] is proved to the nth row. Data line VDATAk (k=j, j+1) is proved to the kth column. The address line SEL[n] corresponds to SEL[n] of Figure 35. The control line CNT[n] corresponds to CNT[n] of Figure 35. The data Line VDATAk (k=j, j+1) corresponds to VDATA of Figure 35.

A gate driver 1306 drives SEL[n]. A data driver 1308 generates a programming data and drives VDATAk. A controller 1310 controls the drivers 1306 and 1308 to drive the pixels 500 to produce the waveforms of Figure 36.

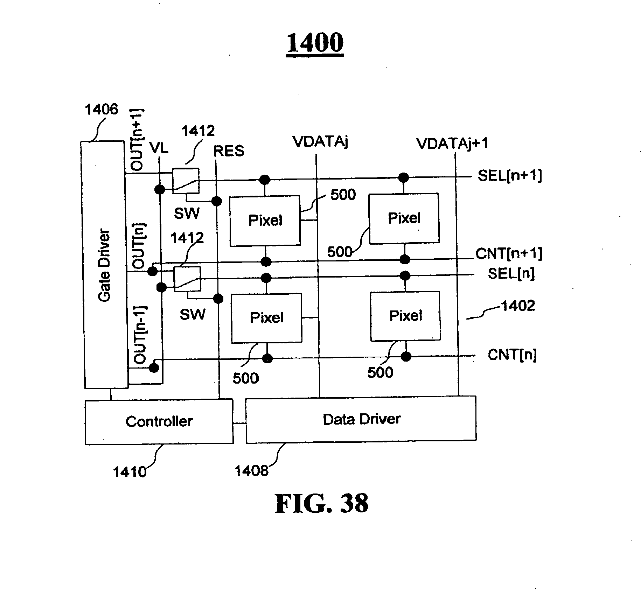

Figure 38 illustrates another example of a display system including the pixel circuit 500 of Figure 35. The display system 1400 of Figure 38 includes a display array 1402 having a plurality of pixels 500. The display array 1402 is an active matrix light emitting display. In one example, the display array 1302 is an AMOLED display array. The pixels 500 are arranged in rows and columns. In Figure 38, four pixels 500 for the nth row are shown. The display array 1402 may include more than four pixels.

SEL[i] (i=n, n+1) is a select line and corresponds to SEL[n] of Figure 35. CNT[i] (i=n, n+1) is a control line and corresponds to CNT[n] of Figure 35. OUT[k] (k=n-1, n, n+1) is an output from a gate driver 1406. The select line is connectable to one of the outputs from the gate driver 1402 or VL line. VDATAm (m=j, j+1) is a data line and corresponds to VDATA of Figure 35. VDATAm is controlled by a data driver 1408. A controller 1410 controls the gate driver 1406 and the data driver 1408 to operate the pixel circuit 500.

The control lines and select lines share the same output from the gate driver 1406 through switches 1412. During the discharge cycle 526 of Figure 36, RES signal changes the switches 1412 direction and connect the select lines to the VL line which has a low voltage to turn off the transistor 508 of the pixel circuit 500. OUT[n-1] is high and so CNT[n] is high. Thus the voltage at node A5 is adjusted by the adjusting circuit 516 and discharging transistor 510. During other operation cycles, RES signal and switches 1412 connect the select lines to the corresponding output of the gate driver (e.g., SEL[n] to OUT[n]). The switches 1412 can be fabricated on the panel using the panel fabrication technology (e.g. amorphous silicon) or it can be integrated inside the gate driver.

According to the embodiments of the present invention, the drive circuit and the waveforms applied to the drive circuit provide a stable AMOLED display despite the instability of backplane and OLED. The drive circuit and its waveforms reduce the effects of differential aging of the pixel circuits. The pixel scheme in the embodiments does not require any additional driving cycle or driving circuitry, resulting in a row cost application for portable devices including mobiles and PDAs. Also it is insensitive to the temperature change and mechanical stress, as it would be appreciated by one of ordinary skill in the art.

One or more currently preferred embodiments have been described by way of examples as described above. It will be apparent to persons skilled in the art that a number of variations and modifications can be made without departing from the scope of the invention as defined in the claims.

## Claims

1. A display system, comprising:
a drive circuit (104, 164, 164A, 214) for a pixel (100, 130, 160, 160A, 160B, 190, 210, 240) having a light emitting device (102, 132, 162, 212, 242), comprising:
a drive transistor (106, 166, 216) connected to the light emitting device, the drive transistor including a gate terminal, a first terminal and a second terminal;
a first transistor (110, 170, 220) including a gate terminal, a first terminal and a second terminal, the gate terminal of the first transistor being connected to a select line (SEL), the first terminal of the first transistor being connected to a data line (VDATA);
a storage capacitor (112, 174, 224) including a first terminal and a second terminal, the first terminal of the storage capacitor being connected to the gate terminal of the drive transistor at a node (A1, A2, A3), the second terminal of the storage capacitor (112, 174, 224) being connected to the second terminal of the drive transistor (106, 166, 216), wherein the storage capacitor is adapted such that the storage capacitor is charged according to a programming voltage during a programming cycle; and
**characterized by**
a circuit for adjusting the gate voltage of the drive transistor (106, 166, 216), the circuit including:
a discharging transistor (108, 168, 218) having a gate terminal, a first terminal and a second terminal, the first terminal of the discharging transistor being connected to the gate terminal of the drive transistor, the gate terminal of the discharging transistor being directly connected to the gate terminal of the drive transistor, the second terminal of the discharging transistor being directly connected to the second terminal of the drive transistor (106, 166, 216); and
wherein the voltage of the storage capacitor at the node is discharged through the discharging transistor in a cycle following the programming cycle.

2. A display system according to claim 1, wherein the circuit for adjusting comprises:
a second transistor (172, 178, 222) having a gate terminal, a first terminal and a second terminal, the first terminal of the discharging transistor being connected to the gate terminal of the drive transistor (166, 216) through the second transistor;
wherein the gate terminal of the second transistor is connected to a bias line (VB, SEL[n+1]). the first terminal of the second transistor being connected to the gate terminal of the drive transistor (166, 216), the second terminal of the second transistor being connected to the first terminal of the discharging transistor (168, 218), or alternatively
wherein the gate terminal and the first terminal of the second transistor (172) are connected to the gate terminal of the drive transistor (166), the second terminal of the second transistor being connected to the first terminal of the discharging transistor (168).

3. A display system according to any one of claims 1 or 2, wherein the first terminal of the drive transistor (106, 166, 216), or a combination of the second terminal of the drive transistor (106, 166, 216), the second terminal of the discharging transistor (108, 168, 218) and the second terminal of the storage capacitor (112, 174, 224) is connected to the light emitting device (102, 162, 192, 212, 242).

4. A display system according to any one of claims 1 to 3, wherein the circuit for adjusting comprises:
a resistor element (178) having a first terminal and a second terminal, the first terminal of the resistor element being connected to the gate terminal of the drive transistor (166), the second terminal of the resistor element being connected to the first terminal of the discharging transistor (168).

5. A display system according to any one of claims 1 to 4, wherein the light emitting device (102, 162, 192, 212, 242) comprises a first electrode, a second electrode, and an emission layer between the first electrode and the second electrode, and
wherein the first terminal of the drive transistor (106, 166, 216) is connected to one of the first electrode and the second electrode, and wherein the second terminal of the drive transistor, the second terminal of the discharging transistor (108, 168, 218) and the second terminal of the storage capacitor (112, 174, 224) are connected to a power supply (134, 176, 246); or alternatively,
wherein the second terminal of the drive transistor (106, 166, 216), the second terminal of the discharging transistor (108, 168, 218) and the second terminal of the storage capacitor (112, 174, 224) are connected to one of the first electrode and the second electrode, and wherein the first terminal of the drive transistor is connected to a power supply (VDD).

6. A display system according to any one of claims 1 to 5, further comprising:
a display array (1002, 1022, 1042, 1062) including a plurality of pixel circuits (1004, 1024, 1044, 1064) arranged in rows and columns, each of the pixel circuits including the drive circuit (104, 164, 164A, 214), and
a driver (1006, 1008; 1026, 1028; 1046, 1048; 1066, 1068) for driving the display array.

7. A display system according to claim 2, further comprising:
a display array (1022, 1062) including a plurality of pixel circuits (1024, 1064) arranged in rows and columns, each of the pixel circuits including the drive circuit (164, 214), and
a driver for driving the display array,
the bias line (VB, SEL[n+1]) being shared by more than one pixel circuit of the plurality of pixel circuits,
wherein, in particular, in the bias line (SEL[n+1]) for a row is an adjacent address line for selecting an adjacent row.

8. A method of driving the display system according to claim 7, comprising providing by the driver a programming cycle (250), a compensation cycle (252) and a driving cycle (254) for each row,
at the programming cycle for a first row, selecting the address line (SEL[n]) for the first row and providing programming data (VDATA) to the first row,
at the compensation cycle for the first row, selecting the adjacent address line (SEL[n+1]) for a second row adjacent to the first row and disenabling the address line for the first row, and
at the driving cycle for the first row, disenabling the adjacent address line, wherein, in particular, at least the compensation cycle for the first row overlaps with the programming cycle for the second row.

9. A display system according to any one of claims 1 to 7, wherein the drive circuit (104, 164, 164A, 214) is formed in amorphous, poly, n-type, p-type, CMOS, microcrystalline, nanocrystalline, crystalline silicon, organic semiconductor or combinations thereof.

10. A display system according to any one of claims 1 to 7 and 9, wherein the second terminal of the drive transistor (106, 166, 216) is a source terminal and the second terminal of the discharging transistor (108, 168, 218) is a source terminal.

11. The method according to claim 8, wherein the drive circuit (104, 164, 164A, 214) is formed in amorphous, poly, n-type, p-type, CMOS, microcrystalline, noncrystalline, crystalline silicon, organic semiconductor or combinations thereof.

12. The method according to claim 8, wherein the second terminal of the drive transistor (106, 166, 216) is a source terminal and the second terminal of the discharging transistor (108, 168, 218) is a source terminal.

## Patentansprüche

1. Displaysystem, das Folgendes umfasst:
eine Ansteuerschaltung (104, 164, 164A, 214) für ein Pixel (100, 130, 160, 160A, 160B, 190, 210, 240) mit einer lichtemittierenden Einrichtung (102, 132, 162, 212, 242), umfassend:
einen Ansteuertransistor (106, 166, 216), der mit der lichtemittierenden Einrichtung verbunden ist, wobei der Ansteuertransistor einen Gateanschluss, einen ersten Anschluss und einen zweiten Anschluss enthält;
einen ersten Transistor (110, 170, 220) mit einem Gateanschluss, einem ersten Anschluss und einem zweiten Anschluss, wobei der Gateanschluss des ersten Transistors mit einer Wahlleitung (SEL) verbunden ist, wobei der erste Anschluss des ersten Transistors mit einer Datenleitung (VDATA) verbunden ist;
einen Speicherkondensator (112, 174, 224) mit einem ersten Anschluss und einem zweiten Anschluss, wobei der erste Anschluss des
Speicherkondensators an einem Knoten (A1, A2, A3) mit dem Gateanschluss des Ansteuertransistors verbunden ist, der zweite Anschluss des Speicherkondensators (112, 174, 224) mit dem zweiten Anschluss des Ansteuertransistors (106, 166, 216) verbunden ist, wobei der Speicherkondensator derart ausgelegt ist, dass der Speicherkondensator gemäß einer Programmierspannung während eines Programmierzyklus geladen wird; und
**gekennzeichnet durch**
eine Schaltung zum Einstellen der Gatespannung des Ansteuertransistors (106, 166, 216), wobei die Schaltung Folgendes enthält:
einen Entladetransistor (108, 168, 218) mit einem Gateanschluss, einem ersten Anschluss und einem zweiten Anschluss, wobei der erste Anschluss des Entladetransistors mit dem Gateanschluss des Ansteuertransistors verbunden ist, der Gateanschluss des Entladetransistors direkt mit dem Gateanschluss des Ansteuertransistors verbunden ist, der zweite Anschluss des Entladetransistors direkt mit dem zweiten Anschluss des Ansteuertransistors (106, 166, 216) verbunden ist; und
wobei die Spannung des Speicherkondensators am Knoten durch den Entladetransistor in einem Zyklus nach dem Programmierzyklus entladen wird.

2. Displaysystem nach Anspruch 1, wobei die Schaltung zum Einstellen Folgendes umfasst:
einen zweiten Transistor (172, 178, 222) mit einem Gateanschluss, einem ersten Anschluss und einem zweiten Anschluss, wobei der erste Anschluss des Entladetransistors durch den zweiten Transistor mit dem Gateanschluss des Ansteuertransistors (166, 216) verbunden ist;
wobei der Gateanschluss des zweiten Transistors mit einer Biasleitung (VB, SEL[n+1]) verbunden ist, der erste Anschluss des zweiten Transistors mit dem Gateanschluss des Ansteuertransistors (166, 216) verbunden ist, der zweite Anschluss des zweiten Transistors mit dem ersten Anschluss des Entladetransistors (168, 218) verbunden ist, oder alternativ
wobei der Gateanschluss und der erste Anschluss des zweiten Transistors (172) mit dem Gateanschluss des Ansteuertransistors (166) verbunden sind, der zweite Anschluss des zweiten Transistors mit dem ersten Anschluss des Entladetransistors (168) verbunden ist.

3. Displaysystem nach einem der Ansprüche 1 oder 2, wobei der erste Anschluss des Ansteuertransistors (106, 166, 216) oder eine Kombination aus dem zweiten Anschluss des Ansteuertransistors (106, 166, 216), dem zweiten Anschluss des Entladetransistors (108, 168, 218) an dem zweiten Anschluss des Speicherkondensators (112, 174, 224) mit der lichtemittierenden Einrichtung (102, 162, 192, 212, 242) verbunden ist.

4. Displaysystem nach einem der Ansprüche 1 bis 3, wobei die Schaltung zum Einstellen Folgendes umfasst:
ein Widerstandselement (178) mit einem ersten Anschluss und einem zweiten Anschluss, wobei der erste Anschluss des Widerstandselements mit dem Gateanschluss des Ansteuertransistors (166) verbunden ist, der zweite Anschluss des Widerstandselements mit dem ersten Anschluss des Entladetransistors (168) verbunden ist.

5. Displaysystem nach einem der Ansprüche 1 bis 4, wobei die lichtemittierende Einrichtung (102, 162, 192, 212, 242) eine erste Elektrode, eine zweite Elektrode und eine Emissionsschicht zwischen der ersten Elektrode und der zweiten Elektrode umfasst und
wobei der erste Anschluss des Ansteuertransistors (106, 166, 216) mit einer der ersten Elektrode und der zweiten Elektrode verbunden ist und wobei der zweite Anschluss des Ansteuertransistors, der zweite Anschluss des Entladetransistors (108, 168, 218) und der zweite Anschluss des Speicherkondensators (112, 174, 224) mit einer Stromversorgung (134, 176, 246) verbunden sind, oder alternativ
wobei der zweite Anschluss des Ansteuertransistors (106, 166, 216), der zweite Anschluss des Entladetransistors (108, 168, 218) und der zweite Anschluss des Speicherkondensators (112, 174, 224) mit einer der ersten Elektrode und der zweiten Elektrode verbunden sind und wobei der erste Anschluss des Ansteuertransistors mit einer Stromversorgung (VDD) verbunden ist.

6. Displaysystem nach einem der Ansprüche 1 bis 5, das weiterhin Folgendes umfasst:
ein Displayarray (1002, 1022, 1042, 1062) mit mehreren Pixelschaltungen (1004, 1024, 1044, 1064), die in Zeilen und Spalten angeordnet sind, wobei jede der Pixelschaltungen die Ansteuerschaltung (104, 164, 164A, 214) enthält, und
einen Treiber (1006, 1008; 1026, 1028; 1046, 1048; 1066, 1068) zum Ansteuern des Displayarrays.

7. Displaysystem nach Anspruch 2, das weiterhin Folgendes umfasst:
ein Displayarray (1022, 1062) mit mehreren Pixelschaltungen (1024, 1064), die in Zeilen und Spalten angeordnet sind, wobei jede der Pixelschaltungen die Ansteuerschaltung (164, 214) enthält, und
einen Treiber zum Ansteuern des Displayarrays,
wobei die Biasleitung (VB, SEL[n+1]) von mehr als einer Pixelschaltung der mehreren Pixelschaltungen gemeinsam verwendet wird,
wobei insbesondere in der Biasleitung (SEL[n+1]) für eine Zeile eine benachbarte Adressleitung zum Wählen einer benachbarten Zeile ist.

8. Verfahren zum Ansteuern des Displaysystems nach Anspruch 7, umfassend das Bereitstellen eines Programmierzyklus (250), eines Kompensationszyklus (252) und eines Ansteuerzyklus (254) für jede Zeile durch den Treiber,
bei dem Programmierzyklus für eine erste Zeile, Wählen der Adressleitung (SEL[n]) für die erste Zeile und Liefern von Programmierdaten (VDATA) an die erste Zeile,
bei dem Kompensationszyklus für die erste Zeile, Wählen der benachbarten Adressleitung (SEL[n+1]) für eine zweite Zeile bei der ersten Zeile und Deaktivieren der Adressleitung für die erste Zeile und
bei dem Ansteuerzyklus für die erste Zeile, Deaktivieren der benachbarten Adressleitung,
wobei insbesondere mindestens der Kompensationszyklus für die erste Zeile den Programmierzyklus für die zweite Zeile überlappt.

9. Displaysystem nach einem der Ansprüche 1 bis 7, wobei die Ansteuerschaltung (104, 164, 164A, 214) in amorphem, Poly-, n-, p-, CMOS-, mikrokristallinem, nanokristallinem, kristallinem Silizium, organischem Halbleiter oder Kombinationen davon ausgebildet wird.

10. Displaysystem nach einem der Ansprüche 1 bis 7 und 9, wobei der zweite Anschluss des Ansteuertransistors (106, 166, 216) ein Sourceanschluss ist und der zweite Anschluss des Entladetransistors (108, 168, 218) ein Sourceanschluss ist.

11. Verfahren nach Anspruch 8, wobei die Ansteuerschaltung (104, 164, 164A, 214) in amorphem, Poly-, n-, p-, CMOS-, mikrokristallinem, nanokristallinem, kristallinem Silizium, organischem Halbleiter oder Kombinationen davon ausgebildet wird.

12. Verfahren nach Anspruch 8, wobei der zweite Anschluss des Ansteuertransistors (106, 166, 216) ein Sourceanschluss ist und der zweite Anschluss des Entladetransistors (108, 168, 218) ein Sourceanschluss ist.

## Revendications

1. Système d'affichage, comprenant :
un circuit de commande (104, 164, 164A, 214) pour un pixel (100, 130, 160, 160A, 160B, 190, 210, 240) comportant un dispositif électroluminescent (102, 132, 162, 212, 242), comprenant :
un transistor de commande (106, 166, 216) connecté au dispositif électroluminescent, le transistor de commande comprenant une borne de grille, une première borne et une seconde borne ;
un premier transistor (110, 170, 220) comprenant une borne de grille, une première borne et une seconde borne, la borne de grille du premier transistor étant connectée à une ligne de sélection (SEL), la première borne du premier transistor étant connectée à une ligne de données (VDATA) ;
un condensateur de stockage (112, 174, 224) comprenant une première borne et une seconde borne, la première borne du condensateur de stockage étant connectée à la borne de grille du transistor de commande au niveau d'un noeud (A1, A2, A3), la seconde borne du condensateur de stockage (112, 174, 224) étant connectée à la seconde borne du transistor de commande (106, 166, 216), le condensateur de stockage étant conçu de manière à ce que le condensateur de stockage soit chargé selon une tension de programmation pendant un cycle de programmation ; et
**caractérisé par** :
un circuit de réglage de la tension de grille du transistor de commande (106, 166, 216), le circuit comprenant :
un transistor de décharge (108, 168, 218) comprenant une borne de grille, une première borne et une seconde borne, la première borne du transistor de décharge étant connectée à la borne de grille du transistor de commande, la borne de grille du transistor de décharge étant directement connectée à la borne de grille du transistor de commande, la seconde borne du transistor de décharge étant directement connectée à la seconde borne du transistor de commande (106, 166, 216) ; et
dans lequel la tension du condensateur de stockage au niveau du noeud est déchargée à travers le transistor de décharge au cours d'un cycle postérieur au cycle de programmation.

2. Système d'affichage selon la revendication 1, dans lequel le circuit de réglage comprend :
un second transistor (172, 178, 222) comprenant une borne de grille, une première borne et une seconde borne, la première borne du transistor de décharge étant connectée à la borne de grille du transistor de commande (166, 216) par l'intermédiaire du second transistor ;
dans lequel la borne de grille du second transistor est connectée à une ligne de polarisation (VB, SEL[n+1]), la première borne du second transistor étant connectée à la borne de grille du transistor de commande (166, 216), la seconde borne du second transistor étant connectée à la première borne du transistor de décharge (168, 218) ; ou selon une variante,
dans lequel la borne de grille et la première borne du second transistor (172) sont connectées à la borne de grille du transistor de commande (166), la seconde borne du second transistor étant connectée à la première borne du transistor de décharge (168).

3. Système d'affichage selon l'une quelconque des revendications 1 et 2, dans lequel la première borne du transistor de commande (106, 166, 216), ou une combinaison de la seconde borne du transistor de commande (106, 166, 216), de la seconde borne du transistor de décharge (108, 168, 218) et de la seconde borne du condensateur de stockage (112, 174, 224), est connectée au dispositif électroluminescent (102, 162, 192, 212, 242).

4. Système d'affichage selon l'une quelconque des revendications 1 à 3, dans lequel le circuit de réglage comprend :
un élément de résistance (178) comportant une première borne et une seconde borne, la première borne de l'élément de résistance étant connectée à la borne de grille du transistor de commande (166), la seconde borne de l'élément de résistance étant connectée à la première borne du transistor de décharge (168).

5. Système d'affichage selon l'une quelconque des revendications 1 à 4, dans lequel le dispositif électroluminescent (102, 162, 192, 212, 242) comprend une première électrode, une seconde électrode et une couche d'émission entre la première électrode et la seconde électrode, et
dans lequel la première borne du transistor de commande (106, 166, 216) est connectée à la première électrode ou à la seconde électrode, et dans lequel la seconde borne du transistor de commande, la seconde borne du transistor de décharge (108, 168, 218) et la seconde borne du condensateur de stockage (112, 174, 224) sont connectées à une alimentation (134, 176, 246) ; ou selon une variante,
dans lequel la seconde borne du transistor de commande (106, 166, 216), la seconde borne du transistor de décharge (108, 168, 218) et la seconde borne du condensateur de stockage (112, 174, 224) sont connectées à la première électrode ou à la seconde électrode, et dans lequel la première borne du transistor de commande est connectée à une alimentation (VDD).

6. Système d'affichage selon l'une quelconque des revendications 1 à 5, comprenant en outre :
un réseau d'affichage (1002, 1022, 1042, 1062) comprenant une pluralité de circuits de pixel (1004, 1024, 1044, 1064) disposés en rangées et colonnes, chacun des circuits de pixel comprenant le circuit de commande (104, 164, 164A, 214), et
un circuit d'attaque (1006, 1008 ; 1026, 1028 ; 1046, 1048 ; 1066, 1068) servant à attaquer le réseau d'affichage.

7. Système d'affichage selon la revendication 2, comprenant en outre :
un réseau d'affichage (1022, 1062) comprenant une pluralité de circuits de pixel (1024, 1064) disposés en rangées et colonnes, chacun des circuits de pixel comprenant le circuit de commande (164, 214), et
un circuit d'attaque servant à attaquer le réseau d'affichage,
la ligne de polarisation (VB, SEL[n+1]) étant partagée par plusieurs circuits de pixel de la pluralité de circuits de pixel,
dans lequel, en particulier, la ligne de polarisation (SEL[n+1]) d'une rangée comprend une ligne d'adresse adjacente permettant de sélectionner une rangée adjacente.

8. Procédé de commande du système d'affichage selon la revendication 7, consistant à faire en sorte que le circuit d'attaque fournisse un cycle de programmation (250), un cycle de compensation (252) et un cycle de commande (254) pour chaque rangée ;
sélectionner, lors du cycle de programmation d'une première rangée, la ligne d'adresse (SEL[n]) de la première rangée, et fournir des données de programmation (VDATA) à la première rangée ;
sélectionner, lors du cycle de compensation de la première rangée, la ligne d'adresse adjacente (SEL[n+1]) d'une seconde rangée adjacente à la première rangée, et désactiver la ligne d'adresse de la première rangée ; et
désactiver, lors du cycle de commande de la première rangée, la ligne d'adresse adjacente,
dans lequel, en particulier, au moins le cycle de compensation de la première rangée chevauche le cycle de programmation de la seconde rangée.

9. Système d'affichage selon l'une quelconque des revendications 1 à 7, dans lequel le circuit de commande (104, 164, 164A, 214) est formé dans un semiconducteur organique en silicium amorphe, en polysilicium, en silicium de type N, en silicium de type P, en silicium CMOS, en silicium microcristallin, en silicium nanocristallin, en silicium cristallin ou dans des combinaisons de ceux-ci.

10. Système d'affichage selon l'une quelconque des revendications 1 à 7 et 9, dans lequel la seconde borne du transistor de commande (106, 166, 216) est une borne de source, et la seconde borne du transistor de décharge (108, 168, 218) est une borne de source.

11. Procédé selon la revendication 8, dans lequel le circuit de commande (104, 164, 164A, 214) est formé dans un semiconducteur organique en silicium amorphe, en polysilicium, en silicium de type N, en silicium de type P, en silicium CMOS, en silicium microcristallin, en silicium non cristallin, en silicium cristallin ou dans des combinaisons de ceux-ci.

12. Procédé selon la revendication 8, dans lequel la seconde borne du transistor de commande (106, 166, 216) est une borne de source, et la seconde borne du transistor de décharge (108, 168, 218) est une borne de source.
